# EUROPÄISCHE PATENTSCHRIFT

(11) **EP 2 926 199 B1**
(45) Veröffentlichungstag und Bekanntmachung des Hinweises auf die Patenterteilung: **23.09.2020**
(21) Anmeldenummer: 13811561.3
(22) Anmeldetag: 20.12.2013
(51) Int. Cl.: G03F 9/00, G03F 7/20

(54) **LITHOGRAPHIEVERFAHREN UND LITHOGRAPHIEVORRICHTUNG FÜR BAUTEILE UND SCHALTUNGEN MIT STRUKTURABMESSUNGEN IM MIKRO- UND NANOBEREICH**
LITHOGRAPHY METHOD AND LITHOGRAPHY DEVICE FOR COMPONENTS AND CIRCUITS HAVING MICROSCALE AND NANOSCALE STRUCTURAL DIMENSIONS
PROCÉDÉ LITHOGRAPHIQUE ET DISPOSITIF LITHOGRAPHIQUE POUR DES COMPOSANTS ET DES CIRCUITS AYANT DES DIMENSIONS STRUCTURALES DU DOMAINE MICROMÉTRIQUE ET NANOMÉTRIQUE

(30) Priorität: 31.12.2012 DE 102012224537
(43) Veröffentlichungstag der Anmeldung: 07.10.2015
(73) Patentinhaber: Technische Universität Ilmenau, 98693 Ilmenau (DE)
(72) Erfinder: KÄSTNER, Markus, 96523 Steinach (DE); RANGELOW, Ivo W., 34225 Baunatal (DE); HOFER, Manuel, 98693 Ilmenau (DE)
(74) Vertreter: Manitz Finsterwald Patent- und Rechtsanwaltspartnerschaft mbB
(86) Internationale Anmeldenummer: PCT/EP2013/077664
(87) Internationale Veröffentlichungsnummer: WO 2014/102187

(56) Entgegenhaltungen:
- ISHIBASHI M. ET AL.: "Combining Atomic Force Microscopic Lithography with Photolithography", JPN. J. APPL. PHYS., Bd. 39, 1. Dezember 2000 (2000-12-01), - 31. Dezember 2000 (2000-12-31), Seiten 7060-7062, XP002725782,
- KAESTNER M, RANGELOW I.W.: "Multi-step Scanning Probe Lithography (SPL) on Calxarene with Overlay Alignment", SPIE PROCEEDINGS, Bd. 8323, 1. März 2012 (2012-03-01), XP002725783, DOI: 10.1117/12.916263

## Beschreibung

### Gebiet der Erfindung

Die vorliegende Erfindung betrifft ein Lithographieverfahren und eine Lithographievorrichtung bei dem bzw. bei der ein von einer Rastersonde erzeugtes elektrisches Feld und ein daraus resultierender Feldemissions-/Tunnel-/Faraday'scher- Elektronenstrom zur Bearbeitung einer Resistschicht verwendet wird. Ein Verfahren bzw. eine Vorrichtung dieser Art ist aus der WO2005/088399 bekannt, die der DE102004002179 A1 entspricht, zu der weiter unten Stellung genommen wird.

Hilfreich für ein Verständnis der Terminologie von Lithographieverfahren ist eine Erläuterung der Begriffe Positivresist und Negativresist. Bei einem Positivresist wird das Resistmaterial durch die Einwirkung der Strahlung in der Weise verändert, dass es an den bestrahlten bzw. belichteten Stellen beispielsweise mit Hilfe einer geeigneten Entwicklungsflüssigkeit entfernt werden kann. Bei einem Negativresist verhält es sich umgekehrt, d.h. die bestrahlten bzw. belichteten Stellen sind gegenüber der Entwicklungsflüssigkeit unempfindlich, stattdessen werden die nicht bestrahlten bzw. belichteten Bereiche durch die Entwicklungsflüssigkeit entfernt.

### Beschreibung des Standes der Technik

Gemäß der in der DE10 2004 059 147 beschriebene Vorgehensweisen werden ein Verfahren zum Übertragen von groben und feinen Strukturen in ein Substrat beschrieben, wobei in einem ersten Bereich des Substrats grobe Strukturen und in einem zweiten Bereich des Substrats feine Strukturen ausgebildet werden.

Zum Stand der Technik werden in der DE10 2004 059 147 auf Mikroelektronische Bausteine, wie beispielsweise DRAM (Dynamic Random Access Memory) - Speicherzellen verwiesen, bei denen strukturierte Schichten aus unterschiedlichen Substraten, wie Metalle, Dielektrika oder Halbleitermaterial, auf einem Halbleiterwafer angeordnet sind. Zur Strukturierung der Schichten kann beispielsweise ein photolithographisches Verfahren angewendet werden. Dabei wird eine auf das zu strukturierende Substrat aufgebrachte, auch als Resist bezeichnete lichtempfindliche Polymerschicht mittels einer Photomaske, welche die in das Substrat zu übertragenden Strukturen aufweist, und einer photolithographischen Abbildungsvorrichtung, abschnittsweise einer Lichtstrahlung ausgesetzt. Das Resistmaterial wird durch die Einwirkung des Lichtes so verändert, dass es an den belichteten Stellen unlöslich bezüglich einer Entwicklerflüssigkeit wird. Folglich wird mit der Entwicklerflüssigkeit nur das unbelichtete Resistmaterial entfernt, was einem Negativresist entspricht.

Nach der Entwicklung des Resists sind die Strukturen von der Photomaske in den Resist in Form von Öffnungen übertragen worden. Das Übertragen der Strukturen vom Resist in das Substrat erfolgt durch einen nachfolgenden Ätzschritt. Der Resist hat dann die Funktion einer Ätzmaske. An den Stellen, an denen das Resistmaterial durch die Entwicklerflüssigkeit entfernt wurde, liegt das Substrat frei und kann geätzt werden.

In Abhängigkeit von der Größe der zu übertragenden Strukturen werden optische Lithographieverfahren, die mit unterschiedlichen Lichtwellenlängen abbilden, eingesetzt. Grobe Strukturen, deren kleinste Dimension etwa bis zu 60 Nanometern reicht, können mit einer Abbildungsvorrichtung mit Lichtwellenlängen aus dem DUV (Tiefer Ultra Violett)-Bereich in den Resist abgebildet werden. Beispielsweise lässt sich mit einer Abbildungsvorrichtung, die mit Licht mit einer Lichtwellenlänge von 248 Nanometern arbeitet, eine Auflösung von 90 Nanometern erreichen. Bei einer Lichtwellenlänge von 193 Nanometern können Abstände bis zu 60 Nanometern aufgelöst werden. Feine Strukturen unterhalb von 60 Nanometern werden bei einem optischen Lithographieverfahren mit kürzeren Lichtwellenlängen beispielsweise im EUV (Extremer Ultra Violett)-Bereich abgebildet. Zukünftig soll eine Lichtwellenlänge von 13,4 Nanometern, welche im extremen Ultra Violett Bereich liegt, in Abbildungsvorrichtungen eingesetzt werden. Damit lässt sich eine Auflösung von circa 30 bis 20 Nanometern erreichen. Um feine Strukturen in den Resist abzubilden, können nicht nur optische Lithographieverfahren angewendet werden, sondern beispielsweise auch Elektronenstrahllithographieverfahren, mit denen feine Strukturen kleiner 40 nm direkt 1:1 in den Resist geschrieben werden.

Neben der Erzeugung von feinen Strukturen in Resistschichten durch Photonen (Optische Lithographie) und Elektronen (Elektronenstrahllithographie), können ebenfalls mit Ionen (Ionenstrahllithographie), im speziellen leichten Ionen wie Ga⁺, He⁺, Ne⁺, Li⁺ feine Strukturen 1:1 in ein Resistmaterial wie auch [Dip-Pen Lithographie [Direct Patterning of Modifed Oligonucleotides on Metals and Insulators by Dip-Pen Nanolithography; 7 JUNE 2002 VOL 296 SCIENCE www.sciencemag.org] oder Nano-Imprint-Lithographie (US Pat. 5,772,905 /Jun. 3.1998) geschrieben werden.

Sollen unterschiedliche Strukturgrößen, also grobe und feine Strukturen auf eine zu strukturierende Schicht übertragen werden, so werden beispielsweise bei der beschleunigten Herstellung von Prototypen unterschiedliche Lithographieverfahren angewendet.

Ein bisher gebräuchliches Verfahren zur Übertragung von groben und feinen Strukturen in ein Substrat läuft nach der Aussage der DE 10 2004 059 147 folgendermaßen ab:
Auf ein Substrat wird als ein Resist ein Positivlack aufgebracht, der bei einer Belichtung mit einer Lichtwellenlänge von beispielsweise 193 Nanometern entwickelbar wird. Groben Strukturen werden dann in einem optischen Lithographieschritt mit einer Lichtwellenlänge von 193 nm (oder kurzer) von einer Photomaske in den Resist abgebildet. Zu jeder für eine lithographische Abbildung verwendeten Lichtwellenlänge gehört üblicherweise auch ein Resist, der bei Belichtung mit der Lichtwellenlänge entwickelbar bezüglich einer Entwicklerlösung wird.

Nach Durchführung eines Temperaturschrittes wird der Resist an den Stellen der belichteten Abschnitte löslich bezüglich einer Entwicklerflüssigkeit. Die groben Strukturen sind nach der Entwicklung als Öffnungen im Resist enthalten.

Anschließend wird der auf dem Substrat angeordnete Resist mit den als Öffnungen ausgebildeten groben Strukturen mit Hilfe eines Ätzschrittes in das Substrat übertragen. Anschließend wird der Resist entfernt.

Nachdem die groben Strukturen in das Substrat eingebracht wurden, wird ein zweiter Resist auf das Substrat aufgebracht. Das Resistmaterial des zweiten Resists kann beispielsweise ein Elektronenstrahllack sein, der empfindlich gegenüber einer Elektronenstrahllithographie ist. Die feinen Strukturen werden dann mit der Elektronenstrahllithographie in den Resist eingeschrieben.

Nach einem weiteren Temperaturschritt wird der Resist entwickelt, wobei die feinen Strukturen, die mittels Elektronenstrahllithographie in den Resist eingeschrieben wurden, durch die Entwicklungsflüssigkeit zu Öffnungen im Resist ausgebildet werden.

Es folgt ein weiterer Ätzschritt mit dem die feinen Strukturen in das Substrat übertragen werden.

Nach der Entfernung des verbleibenden Resists sind nun die groben Strukturen und die feinen Strukturen im Substrat ausgebildet.

Das soeben beschriebene herkömmliche Verfahren ist sehr umständlich, da zuerst ein photoempfindlicher Resist aufgetragen, belichtet und die darunter liegenden Strukturen geätzt werden. Anschließend wird die ganze Prozedur mit einem Elektronenstrahllack wiederholt. Das Verfahren ist umständlich und teuer, da zwei unterschiedliche Resistmaterialien aufgetragen und strukturiert werden müssen.

Die Aufgabe der in der DE 10 2004 059147 beschriebene Erfindung ist es, ein einfaches und kostengünstiges Verfahren zum Übertragen von groben und feinen Strukturen in ein Substrat zur Verfügung zu stellen.

Zur Lösung dieser Aufgabe wird in der DE 10 2004 059147 ein Verfahren zum Übertragen von groben und feinen Strukturen in ein Substrat zur Verfügung gestellt, wobei in einem ersten Bereich des Substrats die groben Strukturen und in einem zweiten Bereich des Substrats die feinen Strukturen ausgebildet werden. Zunächst wird gemäß der dortigen Lösung ein Resist auf das Substrat aufgebracht. Dabei wird dort ein Resistmaterial in der Weise vorgesehen, dass der Resist eine Empfindlichkeit bezüglich unterschiedlicher Belichtungstechniken aufweist, mit denen die groben und die feinen Strukturen in den Resist abgebildet werden können. Die groben und die feinen Strukturen werden in den Resist abgebildet.

Hierbei ist es jedoch notwendig, dass sich die groben und die feinen Strukturen in unterschiedlichen Bereichen des Substrates befinden. Eine Strukturierung mit mehreren Lithographieverfahren im gleichen Bereich ist dabei nicht vorgesehen bzw. möglich.

Der Resist wird mit einer Entwicklerlösung entwickelt, wobei die groben und die feinen Strukturen als Öffnungen im Resist ausgebildet werden. Mit Hilfe eines Ätzschrittes werden die groben und die feinen Strukturen vom Resist in das Substrat übertragen.

Ferner wird in der DE 10 2004 059147 der Resist so vorgesehen, dass er eine Empfindlichkeit gegenüber mindestens zwei verschiedenen Lithographietechniken aufweist, die geeignet sind, um die groben und die feinen Strukturen in den Resist abzubilden. Die groben Strukturen können dann beispielsweise mit einer optischen Lithographie und die feinen Strukturen mit einer Elektronstrahllithographie in ein und demselben Resist abgebildet werden, der dann an den belichteten Stellen, beziehungsweise an den mit einem Elektronenstrahl geschriebenen Stellen löslich bezüglich einer Entwicklerlösung wird. Das Verfahren verringert die Prozesskomplexität. Es wird ein Belackungs-, Entwicklungs- und Ätzschritt eingespart. Das Verfahren garantiert bei Verwendung von zwei verschiedenen Lithographietechniken mit demselben Resist in einem Strukturierungsschritt eine hohe Auflösung, einen hohen Durchsatz und damit eine Verringerung der Prozesskomplexität und der Kosten.

Vorzugsweise wird in der DE 10 2004 059147 für das Resistmaterial ein chemisch verstärkter Positivlack eingesetzt. Verwendet werden können Standardresistmaterialien, deren chemische Verstärkung durch Photosäuregeneratoren erreicht wird. Die Funktionsweise handelsüblicher Resistmaterialien basiert auf Polymerketten, an denen Schutzgruppen angehängt sind, die die Polymerketten unlöslich gegenüber der Entwicklerlösung machen. Durch die Einwirkung von Photonen werden die Schutzgruppen abgespalten und das Polymer wird an den Stellen, an denen die Schutzgruppen abgespalten wurden, löslich. Chemisch verstärkte Resists wurden entwickelt, um eine Entwickelbarkeit des Resists bei einer niedrigeren Belichtungsdosis zu erhalten. Der chemisch verstärkte Resist enthält neben den Polymerketten mit den Schutzgruppen noch sogenannte Photosäuregeneratoren. Der Photosäuregenerator ist ein Molekül, das beim Auftreffen eines Lichtquants eine starke Säure freisetzt. Bei einem Temperaturschritt nach der Belichtung, der auch als Post Exposure Bake bezeichnet wird, werden die Schutzgruppen, z. B. Ester, katalytisch abgespalten. H⁺ Ionen können weiterreagieren.

Vorzugsweise wird, um die Empfindlichkeit des Resistmaterials bezüglich unterschiedlicher Belichtungstechniken herzustellen, der Resist mindestens oberhalb des zweiten Bereiches in der Weise vorbelichtet, dass nach Durchführung eines Temperaturschrittes in den vorbelichteten Abschnitten des Resists eine chemische Verstärkungsreaktion ausgelöst wird, aber der Resist bezüglich einer Entwicklerlösung noch nicht löslich ist. Durch das Vorbelichten des Resists wird der Resist chemisch verändert und damit seine Empfindlichkeit erhöht. Der Resist kann nun mit unterschiedlichen Lichtwellenlängen belichtet, oder auch für eine Elektronenstrahllithographie eingesetzt werden. Die Belichtungszeiten bei einer optischen Lithographie werden gegenüber einem nicht vorbelichteten Resist deutlich verkürzt. Auch bei der Elektronenstrahllithographie kann die Belichtungsdosis deutlich geringer sein, je nach Kontrast und Empfindlichkeit des Resists, als ohne die Vorbelichtung. Die Verkürzung von Belichtungsdauern führt zu einer Erhöhung des Durchsatzes und damit zu einer Verringerung der Kosten.

In vorteilhafter Weise wird gemäß der DE 10 2004 059147 das Vorbelichten des Resists oberhalb des zweiten Bereiches mittels eines ersten optischen Lithographieschrittes unter Einsatz von Licht mit einer ersten Lichtwellenlänge ausgeführt. Das Abbilden der groben und der feinen Strukturen wird mit Hilfe von zwei Lithographieschritten vorgenommen, wobei die groben Strukturen in dem ersten optischen Lithographieschritt gleichzeitig beim Vorbelichten und die feinen Strukturen mit Hilfe eines zweiten Lithographieschrittes in den Resist abgebildet werden. Für diese Verfahrensvariante kann im ersten optischen Lithographieschritt eine Photomaske verwendet werden, welche die groben Strukturen beinhaltet und ein transparentes oder semitransparentes Gebiet, durch das der Resist oberhalb des zweiten Bereiches vorbelichtet werden kann.

Vorzugsweise wird das Vorbelichten des Resists mittels einer Flutbelichtung des gesamten Resists unter Einsatz von Licht mit einer ersten Lichtwellenlänge durchgeführt. Bei der Flutbelichtung wird der gesamte Resist gleichmäßig vorbelichtet, so dass die Empfindlichkeit des Resists sowohl im ersten als auch im zweiten Bereich erhöht wird. Dadurch lassen sich für alle nachfolgenden Lithographieschritte die Belichtungszeiten verkürzen. Verkürzte Belichtungszeiten bedeuten eine Erhöhung des Durchsatzes, wodurch wiederum die Produktionskosten gesenkt werden können.

In vorteilhafter Weise wird also in der DE 10 2004 059147die Abbildung der groben und der feinen Strukturen in zwei Lithographieschritten vorgenommen, wobei ein erster Lithographieschritt eine optische Lithographie beinhaltet und in dem ersten Lithographieschritt die groben Strukturen in den Resist abgebildet werden und in einem zweiten Lithographieschritt die feinen Strukturen in den Resist abgebildet werden.

Die optische Lithographie kann vorzugsweise mit der ersten Lichtwellenlänge durchgeführt werden. Das heißt, dass mit der Abbildungsvorrichtung sowohl die Flutbelichtung vorgenommen wird, als auch die groben Strukturen in den Resist abgebildet werden.

Vorzugsweise wird gemäß der DE 10 2004 059147 im zweiten Lithographieschritt eine Elektronenstrahllithographie oder eine Ionenprojektionslithographie oder eine optische Lithographie unter Einsatz von Licht mit einer zweiten Lichtwellenlänge eingesetzt. Die genannten Lithographietechniken sind geeignet, um die feinen Strukturen abzubilden.

Vorzugsweise wird gemäß der DE 10 2004 059147 das Abbilden der groben und der feinen Strukturen mittels eines Lithographieschrittes durchgeführt. Die groben und die feinen Strukturen werden dabei mit ein und derselben Lithographietechnik abgebildet.

Vorzugsweise wird gemäß der DE 10 2004 059147 in dem Lithographieschritt eine Elektronenstrahllithographie oder eine Ionenprojektionslithographie, oder eine optische Lithographie bei Verwendung von Licht mit einer zweiten Lichtwellenlänge eingesetzt.

In vorteilhafter Weise wird gemäß der DE 10 2004 059147 die zweite Lichtwellenlänge kürzer als die erste Lichtwellenlänge vorgesehen. Da in der Abbildungsvorrichtung für die optische Lithographie die groben und die feinen Strukturen abgebildet werden, ist es, um eine ausreichende Auflösung zu erzielen, vorteilhaft, die in der Abbildungsvorrichtung eingesetzte zweite Lichtwellenlänge kürzer als die erste Lichtwellenlänge vorzusehen. Auf Grund der Vorbelichtung des Resists weist der Resist eine höhere Empfindlichkeit bezüglich kürzerer Lichtwellenlängen auf.

Vorzugsweise wird in der DE 10 2004 059147 die zweite Lichtwellenlänge im EUV-Bereich vorgesehen. Dies kann beispielsweise eine Lichtwellenlänge von 13,4 Nanometern sein.

Vorzugsweise wird gemäß der DE 10 2004 059147 die erste Lichtwellenlänge im DUV-Bereich vorgesehen. Dies können beispielsweise Lichtwellenlängen von 365, 248 oder 193 Nanometern sein.

In vorteilhafter Weise wird gemäß der DE 10 2004 059147 nach dem Aufbringen des Resists ein Temperaturschritt durchgeführt. Vorzugsweise wird nach der strukturierenden Belichtung vor dem Entwickeln des Resists ein Temperaturschritt durchgeführt.

Als Resistmaterial kann vorzugsweise auch ein Negativlack eingesetzt werden. Der Negativlack weist beispielsweise als Bestandteile ein wässrig alkalisch lösliches Polymer, einen Vernetzter mit mindestens zwei Oxiraneinheiten, eine Photosäure und ein Lösungsmittel auf. Es besteht auch die Möglichkeit, noch eine Base hinzuzusetzen. Weitere Details sind in der DE 10 2004 059147 beschrieben.

Die DE 103 03 040 befasst sich mit einem Verfahren und einer Vorrichtung zur maskenlosen Mikrolithographie.

Wie dort erläutert hängt der Fortschritt in der Forschung und Entwicklung von mikroelektronischen Bauteilen hauptsächlich von den Eigenschaften, den Fähigkeiten und der Flexibilität der mikrolithographischen Geräte ab. Der Fortschritt ist unter anderen in dem Bestreben zur Erzielung von immer feineren Strukturen und somit einer möglichst hohen Packungsdichte begründet. Die Lithographie in der Mikroelektronik ist ein technologischer Prozessschritt, bei dem ein Muster in ein Aufzeichnungsmedium gezeichnet, bzw. projiziert wird. In der Regel ist das Aufzeichnungsmedium ein strahlungsempfindlicher dünner Film, der auch Resist genannt wird. In diesen dünnen Film wird das gewünschte Muster des Bauteils geschrieben und die daraus resultierende Struktur im Medium wird als Maske bezeichnet, wobei Photonen, Elektronen, oder Ionen zum Schreiben verwendet werden. Während des Prozesses bzw. Schreibvorgangs werden im Resist feine Linienmuster ausgebildet, die selektiv das darunterliegende Substrat gegen chemische oder physikalische Einwirkung in den nachfolgenden Prozessschritten, wie z. B. Ätzen, Metallisierung, Dotieren, Implantieren, etc., schützen.

Die Verwendung von Elektronen in der Lithographie ist hauptsächlich auf das seriell arbeitende Direktschreiben auf Substrate oder die Master-Masken Fertigung für andere lithographische Projektionstechniken mit hauptsächlich hohem, parallelem Durchsatz beschränkt.

Die internationale Patentanmeldung WO 00/30146 beschreibt ebenfalls ein Verfahren und eine Anordnung zur Belichtung eines Substrats. Dabei ist das Substrat mit einem aus N-Schichten bestehenden Resistsystem versehen, das mit einer Korpuskularstrahlung belichtet oder bearbeitet wird. Die Anordnung zur Bearbeitung des Resistsystems besteht aus mehreren Kontaktspitzen, die durch ein Federelement mit den verschiedenen Schichten des Resistsystems in Kontakt gebracht werden. Dabei kontaktieren verschiedene Kontaktspitzen unterschiedliche Schichten des Resistsystems, um dadurch eine Aufladung der einzelnen Schichten während der Strukturierung durch die Korpuskularstrahlung zu verhindern. Dennoch erfolgt die Belichtung bzw. Bearbeitung des Substrats weiterhin über eine einzige Quelle der Korpuskularstrahlung, was für die Bearbeitung einer gesamten Wafer- oder Substratoberfläche zeitaufwendig ist.

Der Artikel von Kathryn Wilder und Calvin F. Quate in Journal Vac. Sci. Technol. B 17(6), Nov/Dec 1999, Seiten 3256 bis 3261, offenbart eine Methode zur Lithographie, die einen Ausleger mit einem integrierten Transistor zur Steuerung des Belichtungsstroms umfasst. Die von einer mikrostrukturierten Spitze aufgrund von Feldemission ausgesendeten Elektronen wirken auf einen Resist, bestehend aus einem organischen Polymermaterial, ein. Ein MOSFET ist auf dem Ausleger integriert und kontrolliert den von der Spitze ausgesendeten Strom. Der Ausleger und die Spitze bilden die Senke des MOSFETs.

Die Nachteile des Standes der Technik sind, dass die Direktschreibverfahren und Vorrichtungen, die Elektronen als auch Ionen verwenden, im Vergleich zu lithographischen Projektionstechniken zu langsam sind. Dennoch ermöglicht das Direktschreiben die Herstellung von Masken mit sehr hoher Auflösung, sehr guter Reproduzierbarkeit und ausgezeichnete, feine Strukturen, die für eine Kontrolle der Platzierung und Ausrichtung von Muster und Kanten besonders nützlich sind.

Zum Stand der Technik soll auch auf die DE 103 03 040 verwiesen werden, der die Aufgabe zugrunde liegt, eine Vorrichtung zu schaffen, mit der ein schnelles, sicheres und effizientes Direktschreiben auf einem Wafer oder einem Substrat möglich ist.

Um diese Aufgabe zu lösen wird in der DE 103 03 040 eine Vorrichtung vorgesehen, die mehrere mikrostrukturierte Ausleger aufweist, die in einem Array angeordnet sind, wobei jeder Ausleger des Arrays eine Nadelspitze, einen bimorphen (Bimetall) thermischen Aktuator, einen Piezowiderstandssensor und ein Heizelement enthält, und ferner eine Spannungsversorgungs- und Kontrolleinheit vorgesehen ist, die mit der Nadelspitze, dem Heizelement und dem Piezowiderstandssensor verbunden ist, die Nadelspitze und das Heizelement geeignet bestromt und die am Piezowiderstandssensor erzeugte Spannung empfängt.

Ferner bestand die Aufgabe darin, ein Verfahren zu schaffen, das ein schnelles, sicheres und effizientes Direktschreiben ermöglicht. Dabei soll der Durchsatz von zu schreibenden Masken oder Wafern hoch sein.

Diese Aufgabe(n) wird(werden) mit einem Verfahren gelöst, das die folgenden Schritte umfasst:
- Zusammenbringen mindestens eines Arrays mit Auslegern, von denen jeder eine Nadelspitze trägt, mit einer zu strukturierenden Oberfläche in der Art, dass die Nadelspitzen nahe der zu strukturierenden Oberfläche angeordnet sind.
- Einstellen und Regeln einer Phasenverschiebung und/oder Amplitude und/oder Frequenz der Ausleger in den Arrays mit einer Spannungsversorgungs- und Kontrolleinheit, wobei eine konstante Phasenverschiebung und/oder Amplitude und/oder Frequenz einem konstanten Abstand zwischen der an jedem Ausleger vorgesehenen Nadelspitze und der zu strukturierenden Oberfläche entspricht.
- Ausführen einer Relativbewegung zwischen mindestens einen Array mit Auslegern und der zu strukturierenden Oberfläche.
- Anlegen einer elektrischen Spannung an die Nadelspitze um dadurch ein elektrisches Feld zwischen der Nadelspitze und der zu strukturierenden Oberfläche auszubilden, und
- Steuern der Spannung in Abhängigkeit des auf der zu strukturierenden Oberfläche zu erzeugenden Musters.

Die oben vorgeschlagene Vorrichtung zum Direktschreiben hat den entscheidenden Vorteil, dass sie ein Array von Auslegern aus Silizium umfasst. Die Ausleger sind mit mikroskopischen Herstellungsverfahren, also mikrostrukturiert, gefertigt. Jeder Ausleger besitzt eine Nadelspitze zur gattergesteuerten Feldemission in der Nähe seines freien Endes. Das Substrat ist als Anode aufzufassen und die Nadelspitze ist die Kathode. Die durch die Feldemission erzeugte Spotgröße auf dem Substrat kann durch das Verhältnis der Anodenspannung zu der Kathodenspannung eingestellt werden.

Die eine Elektronenquelle ist eine sogenannte Mikrokathode. Ferner besitzt jeder Ausleger eine Struktur zum Richten und Regeln des Auslegers und der von der Nadelspitze ausgehenden Feldemission. Mit der Feldemission ist die Erzeugung freier Elektronen mit einer sehr geringen Energiebreite möglich. Dabei ist das Richten und Regeln des von der Nadelspitze austretenden Elektronenstrahls und/oder der elektromagnetischen Energie zu verstehen, die an die Nadelspitzen zur Erzeugung der Feldemission anliegt.

Es ist besonders vorteilhaft, dass mehrere mikrostrukturierte Ausleger in einem Array angeordnet sind, wobei in jedem Ausleger des Arrays ein Aktuator integriert ist. Eine Spannungsversorgungs- und Kontrolleinheit ist vorgesehen, die durch eine geeignete Spannung den Abstand des Auslegers bezüglich einer zu strukturierenden Oberfläche anpasst. Jede Nadelspitze ist mit dieser Spannungsversorgungs- und Kontrolleinheit verbunden. In einer besonders vorteilhaften Ausgestaltung ist die Anordnung der Ausleger in dem Array als eine Reihe ausgebildet, und die Länge der Reihe umfasst in etwa den Durchmesser des Wafers, der die zu strukturierende Schicht trägt. Zum Strukturieren der zu bemusternden Oberfläche des Substrats oder der Oberfläche des Wafers ist es erforderlich, dass mindestens ein Array mit Auslegern, von denen jeder eine Nadelspitze trägt, mit der zu strukturierenden Oberfläche derart zusammengebracht werden, dass die Nadelspitzen nahe der zu strukturierenden Oberfläche angeordnet sind. Es werden Oszillationen der in Arrays angeordneten Ausleger erzeugt und der Abstand zwischen der an jedem Ausleger vorgesehenen Nadelspitze und der zu strukturierenden Oberfläche wird in geeigneter Weise geregelt bzw. bei einem konstanten Wert gehalten. Eine Relativbewegung zwischen dem mindestens einen Array mit den Auslegern und der zu strukturierenden Oberfläche ermöglicht eine Strukturierung der gesamten Oberfläche. In einer rasternden Bewegung wird die gesamte Oberfläche des zu bemusternden Substrats oder des zu strukturierenden Wafers überdeckt.

Es soll darauf hingewiesen werden, dass zur Erzeugung der Relativbewegung mehrere Möglichkeiten bestehen, diese umfassen u. A. folgende Möglichkeiten:
- Die Matrixanordnung kann fest angeordnet werden, während das Substrat bzw. der Tisch, der das Substrat trägt, kann beweglich angeordnet werden, bspw. in drei Koordinaten x. y und z,
- Das Substrat bzw. der Tisch, der das Substrat trägt, kann fest angeordnet werden, während die Matrixanordnung beweglich angeordnet werden kann,
   bspw. in drei Koordinaten x. y und z,
- Die Matrixanordnung kann in einer Koordinatenrichtung bewegt werden, beispielsweise in der Z-Richtung, um den Grundabstand zwischen der Matrixanordnung der Ausleger und das Substrat einzustellen, während das Substrat bzw. der Tisch, der das Substrat trägt, in zwei weiteren Koordinatenrichtungen, bspw. in der X-Richtung und in der Y-Richtung beweglich angeordnet werden kann.
- Das Substrat bzw. der Tisch, der das Substrat trägt, kann in einer Koordinatenrichtung bewegt werden, beispielsweise in der Z-Richtung, um den Grundabstand zwischen der Matrixanordnung der Ausleger und das Substrat einzustellen, während die Matrixanordnung der Ausleger in zwei weiteren Koordinatenrichtungen, bspw. in der X-Richtung und in der Y-Richtung, beweglich angeordnet werden kann.

Durch das Anlegen einer elektrischen Spannung an die Nadelspitze wird ein elektrisches Feld zwischen der Nadelspitze und der Oberfläche ausgebildet und die angelegte Spannung wird in Abhängigkeit des auf der Oberfläche zu erzeugenden Musters gesteuert und geregelt. Der Abstand der Nadelspitze des Auslegers zu der zu strukturierenden Oberfläche wird über die gemessene Phasenverschiebung oder Amplitude oder Frequenz eines jeden Auslegers angepasst. Die Richtung des Schwingens der einzelnen Ausleger steht senkrecht zu der zu bemusternden oder strukturierenden Oberfläche des Substrats oder des Wafers. Die Phasenverschiebung / Amplitude / Frequenz ist ein Maß für den Abstand des Auslegers von der zu bemusternden oder strukturierenden Oberfläche. So ist es möglich, dass über die Spannungsversorgungs- und Kontrolleinheit die Phasenverschiebung / Amplitude / Frequenz auf einen konstanten Wert eingestellt werden kann, was wiederum einen konstanten Abstand des Auslegers zu der zu strukturierenden Oberfläche entspricht.

Ein weiteres Verfahren zur elektrostatischen Strukturierung einer Substratoberfläche mittels eines Rastersonden-Lithographieverfahrens wird in der WO2005/088399, die der DE102004002179 A1 entspricht, beschrieben und baut auf das Verfahren und die Vorrichtung gemäß der DE 103 03 040 auf. Wie in der WO2005/088399 erläutert, werden derartige Verfahren u. a. bei der Herstellung von Halbleiterbauelementen neben anderen bzw. ergänzend zu anderen bekannten Oberflächenstrukturierungsverfahren wie Lithographie mit Elektronen-und Röntgenstrahlen und der Photolithographie eingesetzt.

Neben den letztgenannten Lithographie-Verfahren werden insbesondere im Bereich von Nanostrukturen Verfahren der Rastersonden-Elektronenstrahl Lithographie zunehmend zur Strukturierung von Oberflächen eingesetzt, wie in der oben genannten DE 103030404 beschrieben ist. Bei dieser Art der Lithographie wird ein Elektronenstrahl aus einer mit einer elektrischen Spannung beaufschlagten Spitze an einem Ausleger (Biegebalken) eines atomaren Kraftmikroskops-Atomic Force Microscope (AFM) über eine Feldmission ausgestrahlt. Eine unter dem Kraftmikroskop befindliche Substratoberfläche ist mit einem Resist versehen, welcher gegenüber den Elektronenstrahlen empfindlich ist. Der Bereich bzw. Bahn, über welche die Spitze des Kraftmikroskops bewegt wird, wird mit Elektronen belichtet und dabei chemisch modifiziert. Als Resistmaterialien werden bei dieser Lithographieart insbesondere zur Erzeugung von Strukturen im Sub-50-Nanometerbereich eingesetzten Polymere unterschiedlicher Zusammensetzung verwendet. Als Resistmaterialien bei der Rastersonden-Elektronenstrahllithographie sind u. a. auch Calixarene eingesetzt worden.

Calixarene sind [ln]-Metacyclophane, die durch Cyklokondensation von Phenolen und Formaldehyd einfach erhältlich sind. Ihr Name ergibt sich aus der kelchförmigen Gestalt des einfachsten Vertreters der Calixarene, wobei das griechische Wort Calix, Tasse, Vase oder Kelch bedeutet. Die Calixarene weisen eine Fähigkeit auf, neutrale organische Moleküle oder Ionen komplexieren zu können. Sie werden insbesondere als selektive Liganden in der analytischen Chemie, in der Sensortechnik, in der medizinischen Diagnostik sowie bei der Aufarbeitung nuklearer Abfälle und als Mimetika für Enzyme eingesetzt, siehe A. Casnati, "Calixarenes: From chemical curiosity to a rich source for molecular receptors", Gazz. Chim. Ital. 127, 637-649 (1997).

Aus dem US-Patent 5,702, 620 ist ein Verfahren zur ultrafeinen Strukturierung und ein ultrafeines Ätzverfahren unter Benutzung eines Calixarenderivates als Negativresist bekannt geworden. Hierbei wird ein Resistfilm aus 5,11, 17,23, 29,35-Hexa-chloromethyl-37, 38, 39,40, 41, 42-Hexamethoxycalix[6]aren, der für hochenergetische Strahlen empfindlich und in einem Lösungsmittel löslich ist, auf ein durch Trockenätzen ätzbares Substrat aufgebracht. Ein Teil des Filmes wird dabei einem hochenergetischen Elektronenstrahl aus einem in der Mikrostrukturtechnik üblichen Elektronenstrahlschreiber mit Beschleunigungsspannungen von beispielsweise 30-50kV ausgesetzt. Ein anderer, nicht dieser Strahlung ausgesetzter Resistbereich, wird durch ein Lösungsmittel entfernt, so dass nur der durch Strahlung chemisch modifizierte und entwickelte Bereich stehen bleibt, was einer Strukturierung des Substrates entspricht. Das Substrat kann dann anschließend mit einem Trockenätzverfahren weiter behandelt werden.

Auch ist die Verwendung von Calixaren-Derivaten und Calixresorcinaren-Derivaten als positives Photoresist-Material aus der japanischen Patentanmeldung JP 101 465 97 bekannt geworden.

Weitere Ausführungen zu Calixaren-Verbindungen, die sich für maskenlose Lithographie eignen, sowie Ausführungen zu maskenlose Lithographie sind den folgenden Literaturstellen zu entnehmen:
[1] Ivo W. Rangelow, Tzvetan Ivanov, Yanko Sarov, Andreas Schuh, Andreas Frank, Hans Hartmann, Jens-Peter Zöllner, Deirdre L. Olynick, V. Kalchenko; "Nanoprobe maskless lithography", Proc. SPIE-Int. Soc. Opt. Eng. 7637, 10pp (2010).
[2] Marcus Kaestner und Ivo W. Rangelow, "Scanning proximal probe lithography for sub-10 nm resolution on calix[4]resorcinarene", J. Vac. Sci. Technol. B 29, 06FD02 (2011).
[3] Marcus Kaestner und Ivo W. Rangelow, "Scanning probe nanolithography on calixarene", Microelectron. Eng. 97, 96-99 (2012).
[4] Marcus Kaestner und Ivo W. Rangelow, "Multi-step Scanning Probe Lithography (SPL) on Calixarene with Overlay Alignment", Proc. SPIE-Int. Soc. Opt. Eng. 8323, 9pp (2012).

Ein weiteres Verfahren ist die aus Nature Materials Bd. 2,468, 2003 bekannte elektrostatische Nanolithographie von Polymeren unter Benutzung eines atomaren Kraftmikroskops (AFMEN). Dieses AFMEN-Lithographieverfahren ist in der Lage, Strukturen mit Breiten von 1-50 nm dadurch zu erzeugen, dass eine hochleitende Wolframspitze eines atomaren Kraftmikroskops (AFM) über einen Polymerfilm mit einer Schichtdicke von 20 bis 100 nm und einer Oberflächenrauhigkeit von 0,5 bis 1 nm gefahren wird. Dabei ist der als Polymethylmethacrylat (PMMA) ausgeführte Polymerfilm auf einer geerdeten Leiterschicht, einem Au-Pd-Film auf einem Silizium-Wafer, aufgebracht. Wird die Rastersondenspitze in einem Abstand von wenigen Nanometer über den Polymerfilm gebracht und eine Spannung angelegt, so herrscht aufgrund der Spitzengeometrie an der Spitze eine Feldstärke im Bereich von 10⁸-10¹⁰V/m, wobei jedoch ein starker Abfall der Feldstärke zu beobachten ist. Eine Elektronenemission von der Spitze führt zu einem messbaren Stromfluss durch das Polymer, so dass nach Modellrechnungen die Temperatur im Polymerbereich, welcher direkt unterhalb der Spitze liegt, die Glas-Übergangstemperatur Tg übersteigt und sich als Folge eine lokalisierte Zone einer dielektrischen und viskoelastischen Flüssigkeit bildet.

Bei diesem Verfahren wird ein Polymethylmethacrylatfilm abgetragen bzw. strukturiert.

Dieser Film ist ein Polymerfilm, bei dem Monomere zu kettenartig ausgebildeten Makromolekülen verbunden sind. Entlang der Ketten sind die Monomere über kovalente Bindungen stabil miteinander verbunden. Zusätzlich kann die Stabilität des Polymers durch Vernetzung und auch Bindungen zwischen einzelnen Ketten erhöht sein. Dadurch ist es nahezu unmöglich, einzelne Monomere bzw. kleine Gruppen davon aus dem Polymer herauszulösen.

Da die Bindungsenergie der Moleküle innerhalb des Polymers aufgrund der stabilen Kettenmoleküle relativ groß ist, kann mit Hilfe der elektrostatischen Lithographie eine Materialabtragung nicht ohne weiteres erfolgen. So ist eine lokale Überführung des Polymers in einen schmelz- bzw. glasartigen Zustand mit schwächerer Bindungsenergie notwendig, um über elektrostatische Kräfte ein Abtragen der Schicht zu erreichen.

Da die Bindungsenergie in dieser viskoelastischen Schmelzzone schwächer ist als in dem nicht aufgeschmolzenen Restbereich des Polymers mit intakten Ketten, ist in der Schmelzzone eine stärkere Polarisation durch die Spitze des atomaren Kraftmikroskops möglich. Durch das starke elektrische Feld wird der geschmolzene Bereich des Polymers unterhalb der Spitze von dieser derart angezogen, dass sich ein erhaben hervorstehender Bereich ausbildet. Dadurch ist eine Strukturierung im Submikrometerbereich der Polymeroberfläche erreicht worden. Schließlich können bei entsprechend hohen elektrischen Spannungen in der Mitte der angehobenen geschmolzenen Bereiche des Polymers Löcher dadurch gebildet werden, dass von der Spitze Teile des Polymers elektrostatisch angezogen werden. Dabei ist es möglich, die Größe der Löcher bzw. die Tiefe der Löcher durch die benutzten Parameter von elektr. Spannung, Abstand und Verweildauer der Spitze über dem Polymer zu verändern bzw. einzustellen. Es ist sogar möglich, die Polymerschicht lokal vollständig abzutragen und somit Substratbereiche freizulegen. Durch das einem Entfernen der Polymerschicht vorangehende Aufschmelzen ist die erreichbare Strukturbreite der so erzielbaren Strukturen allerdings beschränkt. Zudem treten an den Seiten der erzeugten grabenartigen Strukturen störende Aufwölbungen auf.

Der in der WO2005/088399 bzw. in der DE 102004002179 beschriebenen Erfindung liegt die Aufgabe zugrunde, das Verfahren so weiterzuentwickeln, dass scharf begrenzte Abtragsstrukturen bis hin zu Strukturbreiten von einigen Nanometern erreicht werden.

Gemäß der in der WO-Schrift bzw. in der DE102004002179 A1 beschriebenen Lösung wird eine Substratoberfläche durch Positionieren einer an einem Biegebalken eines atomaren Kraftmikroskops angebrachten Spitze über dem Substrat elektrostatisch strukturiert. Dabei wird zwischen dem Substrat und der Spitze eine elektrische Gleichspannung angelegt. Der Abstand und die angelegte Gleichspannung zwischen Spitze und Substrat werden dabei so gewählt, dass in einem im Wesentlichen unterhalb der Spitze befindlichen Bereich des Substrates Substratmaterial von der Spitze elektrostatisch angezogen wird, und das Substrat an der Substratoberfläche dadurch zumindest teilweise abgetragen wird. Das Verfahren zeichnet sich dadurch aus, dass ein Substrat verwendet wird, das zumindest an der Oberfläche aus Molekülen mit begrenzter Ausdehnung ausgebildet ist, die untereinander im wesentlichen durch schwache intermolekulare Wechselwirkungskräfte wie z. Bsp. van der Waals-Kräfte gebunden sind.

Ferner wird auch ein Rastersonden-Lithographieverfahren mit einer Oberflächenstrukturierung durch elektrostatische Strukturierung eines flächigen Substrates vorgesehen.

Mit Vorteil kann gemäß dem dortigen Vorschlag ein Substrat an seiner Oberfläche abgetragen bzw. bis zu Strukturbreiten von einigen Nanometer strukturiert werden, ohne dass eine Schädigung des Substrates auftritt. Dadurch können ohne Zwischenschaltung von weiteren Behandlungen Prozessschritte wie etwa ein Abtragen, ein Ätzschritt oder ein Lift-off-Schritt, angeschlossen werden. Ebenso kann eine an einer Substratoberfläche vorgesehene dünne Schicht sehr fein strukturiert werden. Das erfindungsgemäße Strukturierungsverfahren erfordert dabei keine vorangehende oder sonstige zusätzliche chemische oder physikalische Behandlung der Oberfläche bzw. des Substrates.

Weiterhin beschreiben Ishibashi et al. ("Combining Atomic Force Microscopic Lithography with Photolithography" in Jpn. J. Appl. Phys. Vol. 39 (2000) pp. 7060-7062) die Verwendung von maskenbasierten Lithographieverfahren vor der Anwendung von AFM-Lithographie.

### Aufgabe der Erfindung

Aufgabe der vorliegenden Erfindung ist es, ein hybrides (Mix und Match) Strukturierungsverfahren für einen großen Strukturierungsbereich (< 10µm bis 1nm) vorzusehen, welches eine signifikante Erweiterung des Prozessfensters und eine Erhöhung des Produktionsdurchsatzes im Vergleich zu dem Prozessfenster und dem Produktionsdurchsatz von bekannten Lithographieverfahren erreicht. Mit anderen Wörtern soll ein vorteilhafter Trade-Off zwischen lithographischer Auflösung und Durchsatz (Wafer pro Stunde) durch Einsatz des neuartigen Mix und Match Lithographieverfahrens erreicht werden, wobei eine Nanometer lithographische Auflösung und ein Nanometer genaues Positionieren lithographischer Strukturen in kritischen Bereichen bei gleichzeitiger Erhaltung des Durchsatzes durchaus gewährleistet werden kann.

### Kurzbeschreibung der erfindungsgemäßen Lösungen und deren Vorteile

Zur Lösung dieser Aufgabe wird erfindungsgemäß ein Lithographieverfahren gemäß Anspruch 1 vorgesehen.

Somit wird durch die Erfindung, sowohl eine Grobstrukturierung als auch eine Feinstrukturierung im selben Resistbereich bzw. Fein- und Grobstruktur überlappend in derselben Resistschicht im selben Resistbereich ermöglicht.

Besonders günstig ist, dass die Rastersonde effizient dazu verwendet werden kann, die genaue Position der Grobstrukturierung vor der Durchführung der Feinstrukturierung zu ermitteln.

Dabei kann die strahlenbasierte Lithographiemethode aus der Gruppe bestehend aus Elektronenstrahllithographie, Ionenstrahllithograpie, optische Lithographie wie DUV und EUV, gewählt werden.

Bei dem erfindungsgemäßen Verfahren ist es möglich, die Resistschicht sowohl vor als auch nach einem Entwicklungsschritt (nasschemische Entwicklung unter Anwendung eines geeigneten Lösemittels, Thermische Entwicklung, Laserbasierte Trockenentwicklung, etc.), zu bearbeiten, d.h. die bereits durch Photonen/Elektronen/Ionen- modifizierte Resiststruktur kann mithilfe der Rastersonden-basierten Lithographiemethode nochmals bearbeitet, d.h. chemisch lokal modifiziert und/oder (je nach angewendeten lithographischen Parametersatz) entfernt werden.

Erfindungsgemäß wird daher eine Abdeckung eines großen Prozessfensters durch Kombination von Rastersonden-basierter Lithographie zur Feinstrukturierung mit einer zweiten strahlungsbasierten (Elektronen, Ionen, Photonen) Lithographiemethode (Optische Lithographie, Elektronenstrahllithographie, Ionenstrahllithographie, etc.) zur Grobstrukturierung erreicht, wobei die Kombination der unterschiedlichen Lithographieverfahren zur Bearbeitung derselben Resistschicht im selben Lithographiebereich bzw. überlappend verwendet wird. Dass bedeutet, dass die Grobstruktur, erstellt mit einer Standard-Lithographiemethode, mit einer Feinstruktur versehen wird, wobei die Feinstrukturierung mithilfe einer Rastersonden-basierten Lithographie erfolgt.

Dies bedeutet im speziellen, dass die durch die strahlungsbasierten Lithographie (optische-, Elektronenstrahl- oder Ionenstrahllithographie, etc.) erzeugten groben Resiststrukturen nochmals mithilfe der Rastersonde zur Schaffung der Feinstruktur chemisch lokal verändert und/oder lokal entfernt werden können.

Die Erfindung ermöglicht die Erzeugung einer großen Bandbreite von Mikro- und Nanostrukturen - von größer 10µm bis zu 1nm - in eine dünne Resistschicht unter Anwendung einer kombinierten (hybriden / Mix und Match) Lithographiemethode, wobei mindestens eine Lithographiestufe durch die Anwendung einer Rastersonde als Lithographiewerkzeug gekennzeichnet ist. Dabei können Nicht-CD, d.h. Grobstrukturen,und CD-Strukturen (CD = Critical Dimension), d.h. Feinstrukturen, in dieselbe Resistschicht, direkt im selben Bereich, in serieller Weise (in zwei Lithographiestufen), erzeugt werden. Dies wird dadurch ermöglicht, das die bereits durch die strahlenbasierten Lithographiestufe (Stufe 1) modifizierten Bereiche (z. Bsp. chemische Vernetzung durch einfallende Strahlung wie Photonen, Elektronen, Ionen) durch die Rastersonden-Lithographiestufe (Stufe 2), welche durch Anwendung einer Rastersonde als Lithographiewerkzeug gekennzeichnet ist, nochmals direkt modifiziert werden können.

Im Vergleich zu der oben genannten Schrift DE 10 2004 059 147 A1 ist von Bedeutung, dass die bereits durch die strahlungsbasierte Lithographie geschriebenen Resiststrukturen (entstanden z. Bsp. durch einen chemischen Vernetzungsvorgang aufgrund der einfallenden Strahlung) noch im selben Bereich bzw. überlappend mittels Rastersonden-basierter Lithographie weiter behandelt wird. Hierdurch können grobe Strukturierungen verfeinert oder repariert werden und es können in einem grobstrukturierten Bereich feine Details eingearbeitet werden, d.h. die Grobstrukturen werden mit einer Feinstruktur ergänzt, umgesetzt mithilfe der zugrundeliegenden Rastersonden-basierten Lithographiemethode.

Die Bezeichnung "grobstrukturiert" soll nicht so verstanden werden, dass die so erzeugte Strukturierung grob ist, sondern so, dass die Abmessungen der Strukturierung mindestens etwa eine Größenordnung größer sind als die "feinstrukturierten" Bereichen, bei denen die lateralen Strukturabmessungen im Bereich von etwa 1nm bis etwa 20nm liegen.

Die Reparatur von Resiststrukturen bzw. die Einarbeitung von Feinstrukturen in die zuvor erzeugten groben Resiststrukturen, welche durch eine erste strahlenbasierte Lithographiemethode (Elektronen-/Photonen- /Ionen- basierte Lithographie) erzeugt wurden, kann vor und/oder nach dem Entwicklungsschritt (nasschemische, thermische, laserbasierte Trocken-Entwicklung) und/oder Temperschritt des Resistmaterials (Post Exposure Bake) mittels Rastersonden-basierter Lithographie durchgeführt werden, was das erfindungsgemäße Verfahren sehr flexibel macht.

Die kritischen Strukturen (CD-Strukturen), d.h. Feinstrukturen, sind dabei dadurch gekennzeichnet, dass diese sehr kleine Strukturabmessungen (typisch < 20nm) besitzen, wobei die Größe (auch Strukturabmessung genannt) und Positionierung (auch Overlay Alignment genannt), der Struktur eine für die Funktion des zu erzeugenden Bauelements kritische Bedeutung einnehmen und dadurch funktionsentscheidend sind.

Zur Erzeugung der funktionsentscheidenden CD-Strukturen, d.h. der Feinstrukturen, bietet die beschriebene Rastersonden-lithographische Methode den Vorteil einer geschlossenen Schleife zwischen Abbildung und Strukturierung mit derselben Vorrichtung. Dies bedeutet, dass man mit ein und derselben Vorrichtung, ohne Wechsel der Rastersonde bzw. des Werkzeuges, und in-situ sowohl die Strukturen abbilden als auch bearbeiten bzw. Lithographie betreiben kann. Dies ermöglicht es mit ein- und demselben Werkzeug in serieller, oder paralleler Weise bei Anwendung eines Arrays aus Rastersonden, die Nicht-CD-Strukturen, d.h. die Grobstrukturen, zunächst abzubilden und diese lokal mit der Rastersonde zu analysieren, wobei im nachfolgenden die Position der Feinstrukturen innerhalb der Grobstrukturen exakt bestimmt und festgelegt wird. Unter Anwendung der vorangegangen Abbildung kann die Feinstruktur mithilfe der Rastersonde lokal exakt positioniert geschrieben werden und direkt danach, in-situ, nur durch Änderung von Parametern, mithilfe des gleichen Werkzeuges bzw. Rastersonde, wieder zur Kontrolle und Analyse der Strukturabmessungen und der Position der funktionsentscheidenden Feinstruktur abgebildet werden. Unter Umständen, bei Auftreten von Fehlern von Größe und/oder Position, kann nochmals ein sogenannter geschlossener Zyklus aus Abbildung und Strukturierung, im näheren auch geschlossenen Schleife genannt, durchgeführt werden, um die entsprechende Feinstruktur zu reparieren. Bei Rastersondentechniken wird eine Rastersonde linienhaft vor- und zurück bewegt und jeweils lateral versetzt über ein Substrat geführt. Die Rastersonde kann nach einer vorgegebenen Linie (Struktur oder Layout) relativ zum Substrat (nicht beweglich) bewegt werden. Dasselbe kann in umgekehrter Weise durchgeführt werden und zuletzt können sich auch die Sonde und das Substrat gleichzeitig relativ zueinander in Bewegung befinden.

So können bereits bei der Definition der wichtigsten funktionellen Strukturen von Nano-Bauelementen deren Funktion durch in-situ Abbildung, Overlay Alignment, Kontrolle und u.U. Reparatur der Feinstrukturen sichergestellt werden. Die geschlossene Schleife beschreibt dabei das direkte aufeinanderfolgen von "Abbildung (Kontrolle) - Lithographie - Abbildung (Kontrolle) - usw." ohne Wechsel der Vorrichtung und ggbfs. des Werkzeuges", was sowohl eine in-situ Kontrolle als auch eine extrem exakte Positionierung jeder einzelnen Lithographiestruktur ermöglicht. Dieses Prinzip einer direkten Abfolge von Abbildung und Lithographie kann auch als eine Art geschlossene Regelschleife verstanden werden, da die in-situ Abbildung wiederum zur Anpassung der Position und Strukturabmessung der lithographischen Zielstruktur herangezogen wird.

Diese Methodik einer geschlossenen Lithographieschleife erlaubt nach vorangegangenem Abbilden des Interessenbereiches die exakte Analyse und Inspektion der Vorstruktur, die Ausrichtung und das Alignment der lithographischen Zielstruktur (welche mit dem Rastersonden-basierten Verfahren geschrieben werden soll) auf die bereits vorhandenen Strukturen, das Schreiben der Zielstruktur unter Anwendung der beschriebenen Rastersondenlithographie und der nachfolgenden Abbildung und Inspektion der geschriebenen Strukturkombination unter Anwendung derselben Vorrichtung für alle einzelnen Prozessschritte.

Es gibt eine ganze Reihe von erfindungsgemäßen Möglichkeiten, das erfindungsgemäße Verfahren in der Praxis anzuwenden. Gemäß einer ersten nicht erfindungsgemäßen Variante (Variante 1) zeichnet sich das Verfahren dadurch aus, dass in einem vorbereitenden Schritt ein Substrat mit Resist beschichtet wird, dass das beschichtete Substrat mittels einer groben Lithographie zur Erzeugung der Grobstrukturen, ausgeführt in Form einer maskenbasierten optischen Lithographie (DUV, EUV, Röntgenstrahlung, usw.) oder einer maskenlosen oder maskenbasierten Elektronen- oder Ionenstrahllithographie, oder Röntgenstrahllithographie oder durch Nanoimprintlithographie, behandelt wird, dass in einem nachfolgenden Lithographieschritt das Substrat mittels einer Feinlithographie zur Erzeugung der Feinstrukuren unter Einsatz der Rastersonden-basierten Lithographie behandelt wird, und dass in einem weiteren Behandlungsschritt ein Entwicklungsverfahren durchgeführt wird.

Gemäß einer zweiten Variante (Variante 2) zeichnet sich die Erfindung dadurch aus, dass in einem vorbereitenden Schritt ein Substrat mit Resist beschichtet wird, dass das beschichtete Substrat mittels einer groben Lithographie zur Erzeugung der Grobstrukturen, ausgeführt in Form einer maskenbasierten optischen Lithographie (DUV, EUV, Röntgenstrahlung, usw.) oder einer maskenlosen und/oder maskenbasierten Elektronen- oder Ionenstrahllithographie oder Röntgenstrahllithographie, dass in einem weiteren Behandlungsschritt ein Entwicklungsverfahren durchgeführt wird und dass in einem nachfolgenden Lithographieschritt das Substrat mittels einer Feinlithographie zur Erzeugung der Feinstrukuren unter Einsatz einer Rastersonden-basierten Lithographie behandelt wird. Dabei wird in einem vorbereitenden Schritt ein Substrat mit dem Resist beschichtet, wobei das beschichtete Substrat mittels einer maskenbasierten optischen Lithographie oder einer maskenlosen Elektronen- oder Ionenstrahllithographie behandelt wird, in einem weiteren Behandlungsschritt ein Entwicklungsverfahren durchgeführt wird und in einem nachfolgenden Lithographieschritt der nach der Entwicklung noch verbleibende Resist mittels einer Rastersonden-basierten "closed loop" Lithographie lokal entfernt wird
Ferner besteht die Erfindung auch darin, die Rastersonden-basierte lithographische Behandlung mehrmals nacheinander einzusetzen. Zum Beispiel zeichnet sich eine weitere Variante der Erfindung dadurch aus, das ein von einer Rastersonde erzeugtes elektrisches Feld und ein daraus resultierender Feldemissions-/Tunnel-/Faraday'scher- Elektronenstrom zur Bearbeitung einer Resistschicht verwendet wird, die anschließend entwickelt wird, und dass die nach der Entwicklung zurückbleibende Resistschicht unter Anwendung der Rastersonde weiter strukturiert wird.

Eine Besonderheit beseht hierbei darin, dass durch geeignete Wahl von Lithographieparametern, wie zum Beispiel angelegte Spannung zwischen Spitze der Rastersonde und Substrat, eingestellter Stromwert, Geschwindigkeit der Rastersonde, Form und Gestalt der Rastersonde, Abstand zwischen Spitze der Rastersonde und Substrat, Umgebungsparameter wie Temperatur, Luftfeuchte, Gaszusammensetzung, Partialdruck der Gase, usw. ein Umschalten zwischen Positiv- und Negativ-Resist-Verhalten erreicht werden kann. Ferner können sogar lokale Abscheidungsprozesse, getriggert durch das lokale elektrische Feld um die Rastersonden-Spitze und/oder dem erzeugten Feldemissions-/Tunnel-/Faraday'scher- Strom eingeleitet werden.

Bei all diesen Varianten ist anzumerken, dass sie nicht nur mit einem unstrukturierten Substrat verwendet werden können, sondern auch mit vorstrukturierten Substraten zur Anwendung gelangen können, wobei die Vorstrukturierung unter Anwendung einer der bisher beschriebenen Varianten oder anderweitig erfolgen kann. Genauso kann die Erfindung von weiteren Strukturierungsmaßnahmen gefolgt werden, die auch unter Anwendung einer der bisher beschriebenen Varianten oder anderweitig erfolgen kann.

Ferner können die Varianten nach Belieben kombiniert werden, beispielsweise kann die zuletzt beschriebene Variante mit der Variante 1 kombiniert werden.

Die oben geschilderten Möglichkeiten lassen die hohe Flexibilität der Erfindung erkennen.

Ferner ist es sehr günstig, dass die Erfindung mit allen gängigen Entwicklungsverfahren kombiniert werden kann, so kann zum Beispiel das Entwicklungsverfahren ein nasschemisches, thermisches oder laserbasiertes Entwicklungsverfahren sein. Auch hier wird ein hohes Maß an Flexibilität gewährleistet.

Das erfindungsgemäße Lithographieverfahren kann anschließend von beliebigen Folgeprozessen gefolgt werden, wie z. Bsp. Strukturübertrag in das darunterliegende Substrat, z. Bsp. durch nasschemische Ätzverfahren und Trockenätzverfahren, oder Abscheidung von Strukturen auf das darunterliegende Substrat durch z. Bsp. Lift-Off-Techniken. Ferner kann eine Weiterverarbeitung auch durch Implantationsverfahren, Metallisierung, ALD usw. erfolgen.

Es kommen eine Vielzahl vom Resistmaterialien in Frage. Beispielsweise kann das Resistmaterial der Resistschicht aus der folgenden Gruppe ausgewählt wird:
- Calixaren und/oder Resorcinaren Derivate, wie zum Beispiel C-methylcalix[4]resorcinaren (C-MC4R, C₃₂H₃₂O₈), oder 4-Methyl-1-acetoxycalix[6]aren (4M1AC6, C₆₀H₆₀O₁₂), oder beliebige Derivate von Calixarenen und Resorcinarenen, welche zum Beispiel auch für Langmuir-Blodgett, Self-Assembly (Selbstorganisation) oder Aufdampf- Schichtpräparationstechniken entsprechend chemisch funktionalisiert sind.
- Resistmaterial, das nicht aus Makromolekülen und/oder Kettenmolekülen besteht, sondern aus Einzelmolekülen mit einer räumlichen Ausdehnung ≤ 2nm, welche in einem nicht-kettenförmigen Zustand, idealerweise nur durch nicht-kovalente chemische Bindungen miteinander verbunden sind (intermolekulare Bindungen), und eine feste Resistschicht von 1 bis 100nm ausbilden, wobei die Resistmoleküle durch eine exakt definierte chemische Zusammensetzung, chemische Struktur, geometrische Ausdehnung und monodisperse, idealerweise minimales Molekulargewicht sich auszeichnen, zum Beispiel Fulleren-basierte Resistmaterialien und Derivate davon und andere molekulare Glasresistmaterialien.
- sogenannte hybride Resistmaterialien, welche sich aus organischen und anorganischen Komponenten zusammensetzen, wie z. Bsp. Au(I)-calix(4)aren diphosphin molekulare Komplexe oder Nanopartikel-Calixarene Komplexe.
- chemisch verstärkte Resistmaterialien, auch CAR's genannt.
- polymerbasierte Resistmaterialien wie PMMA (Polymethylmethacrylat)
- spezielle Elektronenstrahl-spezifische organische und/oder anorganische Resistmaterialien, wie zum Beispiel HSQ.

Die Erfindung befasst sich ferner mit einer Lithographievorrichtung gemäß Anspruch 11.

Die Ausrichteinrichtungen der Rastersonden-basierten Lithographieeinrichtung wird vorzugsweise durch einen oder mehrere der Ausleger der Matrixanordnung oder einen gesonderten Ausleger mit Spitze gebildet, der mit der Steuerung zum Detektieren der Oberflächentopographie und Kanten in der Oberflächentopographie des vorstrukturierten Substrates oder grobstrukturierten Resists.

Die Ausrichteinrichtung der strahlenbasierten Lithographieeinrichtung kann durch einen eigenen Ausleger mit Spitze zusammen mit einer entsprechenden Steuerung gebildet werden, der zum Detektieren der Topographie und Kanten der Oberfläche des vorstrukturierten oder Ausrichtmarken des Substrates verwendet wird. Solche Ausrichteinrichtungen, die unter Anwendung eines Auslegers mit Spitze und einer geeigneten Steuerung sind für sich aus der EP-B-1789853 bekannt.

Die Anwendung dieser erprobten Technologie bei der vorliegenden Erfindung hat den besonderen Vorteil, dass die Ausrichtung sehr schnell von statten geht und somit zu einem hohen Durchsatz beiträgt, wobei die Technologie auch voll kompatibel ist mit dem erfindungsgemäßen Lithographieverfahren.

Die Lithographieeinrichtung zur Durchführung eines maskenbasierten Lithographieverfahrens, ist beispielsweise ausgelegt, um einer Strukturierung des Resists mittels DUV, EUV oder Röntgenstrahlen vorzunehmen.

Alternativ hierzu kann die strahlenbasierte Lithographieeinrichtung zur Durchführung eines maskenlosen Lithographieverfahrens ausgelegt werden, beispielsweise mittels eines Elektronenstrahls oder eines Ionenstrahls. Hierdurch kann eine Strukturierung der Resistschicht aber auch des Substrats selbst vorgenommen werden.

Bei einer strahlenbasierten Lithographieeinrichtung befindet sich das aktive Teil der Einrichtung, wie auch das Substrat und ein etwaiger Halter oder Tisch für das Substrat, in einer Vakuumkammer.

Es ist allerdings nicht nötig, die Rastersonden-basierte Lithographieeinrichtung in einer Vakuumkammer zu verwenden, obwohl dies auch möglich wäre. Stattdessen reicht es aus, wenn die Rastersonden-basierte Lithographieeinrichtung sich in einem Raum bzw. in einer Kammer befindet, in dem bzw. in der die Atmosphäre im Sinne einer Temperaturfestlegung, einer Partikelfreiheit, eines Feuchtigkeitsgrades und einer chemischen Zusammensetzung mit bestimmten Partialdruck der umgebenden Gasen bestimmt ist.

Bei der Verwendung einer strahlenbasierten Lithographieeinrichtung in einer Vakuumkammer und einer Rastersondenlithographieeinrichtung in einem Raum oder Kammer wird vorzugsweise eine Schleuse vorgesehen, die sich zwischen der Vakuumkammer und dem Raum bzw. der Kammer befindet, der bzw. die die Rastersonden-basierte Lithographieeinrichtung umfasst.

Eine solche Schleuse dient dazu, das Vakuum in der Vakuumkammer bei der Herausnahme des Substrats, die durch die Schleuse hindurch erfolgt, weitgehend aufrechtzuerhalten, wodurch das Arbeiten schneller geht, da die Abpumpzeiten für die Vakuumkammer kürzer werden, wodurch der Durchsatz erhöht werden kann.

Besonders günstig ist es, wenn eine Handhabungseinrichtung wie ein Roboter mit Greifer oder eine andere Transfereinrichtung vorgesehen ist, der bzw. die das Substrat zwischen der strahlenbasierten Lithographieeinrichtung und der Rastersonden-basierten Lithographieeinrichtung und/oder umgekehrt bewegt.

Weitere wichtige Ausführungsformen der Erfindung gehen aus der nachfolgenden Beschreibung sowie den Zeichnungen hervor

### Kurzbeschreibung der Figuren

Die Erfindung wird nachfolgend anhand von Ausführungsbeispielen näher erläutert, unter Bezugnahme auf die nachfolgenden Zeichnungen:
- Fig.1: eine schematische Darstellung einer möglichen erfindungsgemäßen Vorrichtung zur Durchführung des erfindungsgemäßen Verfahrens,
- Fig. 2A und 2B: zwei Flussdiagramme zur Erläuterung von Varianten des erfindungsgemäßen Lithographieverfahrens,
- Fig. 3: ein weiteres Flussdiagramm zur Klarstellung, dass die unterschiedliche Lithographieverfahren vielseitig anwendbar sind,
- Fig. 4A und 4B: eine schematische Darstellung eines vorbereiteten, mit einer Resistschicht versehenen Substrates, in einer Draufsicht (Fig. 4A) und in einer Schnittzeichnung (Fig. 4B), entsprechend den mit Pfeilen gekennzeichneten Ebene der Fig. 4A,
- Fig. 5A und 5B: Zeichnungen entsprechend den Fig. 4A und 4B, jedoch nach der Durchführung einer Groblithographie unter Anwendung einer strahlenbasierten Lithographieim Rahmen der Herstellung eines Einzelelektronentransistors (SET), jedoch vor einem Entwicklungsschritt, wobei die mit den Pfeilen gezeigten Schnittebene anders gewählt ist wie in den Fig. 4A und 4B,
- Fig. 6A und 6B: Zeichnungen entsprechend den Fig.5A und 5B, jedoch nach der Durchführung eines Entwicklungsschrittes, wobei die mit den Pfeilen gezeigten Schnittebene gleich gewählt ist wie in den Fig. 5A und 5B,
- Fig. 7A und 7B: Zeichnungen entsprechend den Fig. 6A und 6B, jedoch nach einer Feinstrukturierung, welche im selben Resist und im selben Resistbereich wie die Grobstrukturierung stattfindet, unter Anwendung eines Rastersondenbasierten Lithographieverfahrens zur Fertigstellung der Struktur eines SETs (d.h. in die Grobe Resistruktur werden die feinen Resiststrukturen durch Anwendung einer Rastersonden-basierten Lithographie eingearbeitet), wobei die mit den Pfeilen gezeigte Schnittebene anders gewählt ist wie in den Fig. 6A und 6B,
- Fig. 8A und 8B: Zeichnungen entsprechen dem mittleren Bereich der Fig. 7A und 7B, jedoch zu einem größeren Maßstab, wobei die mit den Pfeilen gezeigte Schnittebene anders gewählt ist wie in den Fig. 7A und 7B,
- Fig. 9A und 9B: AFM-Topographiebilder von erfindungsgemäß hergestellten Strukturen, die innerhalb der Grobstrukturen feinstrukturierte Bereiche, durchgeführt durch die Rastersonden-basierte Lithographie, besitzen.
- Fig. 10: eine Anordnung sehr ähnlich der Anordnung gezeigt in Fig. 1, jedoch in Shear-Force-Modus operierend.

### Konkrete Beschreibung der bevorzugten Ausführungsformen

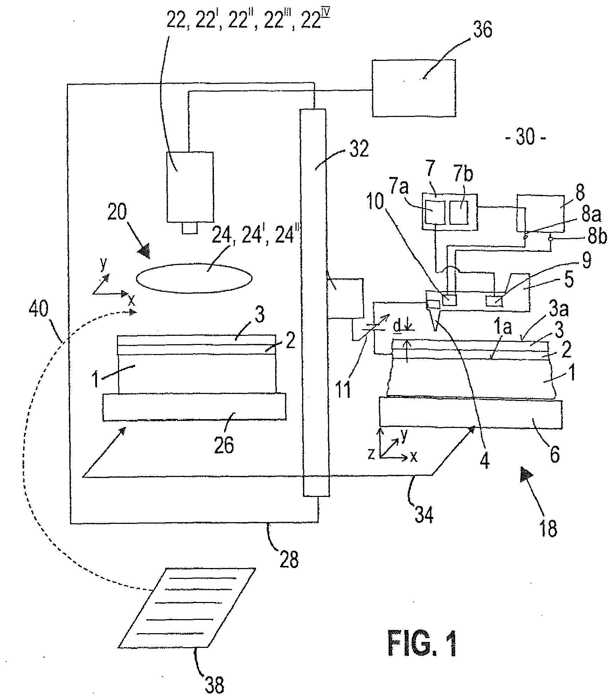

Fig. 1 stellt eine mögliche Anordnung zur Durchführung des erfindungsgemäßen Verfahrens zur Strukturierung einer auf einem Substrat befindlichen Deckschicht bzw. Resistschicht dar.

Auf der rechten Seite der Fig. 1 befindet sich auf einem Substrat 1, das bevorzugt ein Siliziumwafer ist, eine elektrisch leitende Schicht 2, vorzugsweise eine Chrom-Gold-Schicht (CrAu-Schicht). Auf der CrAu-Schicht 3 ist eine filmartige Deckschicht 3 (die Resistschicht) aus einem Calix [n] aren, n = 4 bis 8 aufgebracht. Über der Calixarenschicht 3 ist eine Spitze 4 eines Auslegers 5 (auch Biegebalken oder Cantilever genannt) eines im Detail nicht weiter gezeigten atomaren Kraftmikroskops (AFM), das hier als Rastersondenlithographieeinrichtung 30 beschrieben wird. Die Spitze 4 des Auslegers 5 wird in einem Abstand (d) von 10 bis 100 Ä, d. h. berührungsfrei im sogenannten "non-contact-mode" oberhalb der Resistschicht 3 positioniert. Es soll darauf hingewiesen werden, dass bei der Erprobung der Erfindung zunächst die CrAu- Schicht vorgesehen wurde, um sicherzustellen, dass die Elektronen, die von den Spitzen 4 zum Substrat 1 fließen, ordentlich abfließen, da ein ausgezeichneter Potentialabfall ausgebildet werden kann. Überraschenderweise ist aber nunmehr erfindungsgemäß festgestellt worden, dass eine solche metallisch leitende Schicht überhaupt nicht notwendig ist, sondern, dass es vollkommen ausreicht, wenn eine halbleitende Schicht sich unter der Resistschicht bzw. im Bereich der Spitzen sich befindet. Die oberste Schicht des Substrats kann daher ohne weiteres eine Si-Schicht von n-Typ oder p-Typ sein. So können auch herkömmliche SOI-Wafer oder GaAs -Substrate oder andere gewerblich erhältliche Halbleiterwafer zur Anwendung gelangen.

Ferner können sogar isolierende Schichten, wie zum Beispiel Siliziumdioxid (SiO₂), solange diese dünn genug sind (< 5nm) und sich diese oberhalb eines geeigneten halbleitenden Substrates oder metallischen Schicht befinden, zur Anwendung als oberste Schicht des Substrates, unterhalb der Deckschicht, welche den Resist darstellt, gelangen.

Nach Fig. 1 ist das Substrat 1 auf einem Scannertisch 6 vorgesehen. Der Scannertisch 6 ist dazu ausgebildet, das Substrat 1 in drei aufeinander senkrecht stehenden Raumrichtungen, d. h. in der in der Papierebene liegenden z-Richtung sowie in der dazu senkrechten Ebene (x-, y-Richtung) sehr genau relativ zur Spitze 4 des Auslegers 5 zu bewegen. Eine Bewegung des Scannertisches 6 in z-Richtung entspricht dabei einer Veränderung des Abstands d von Spitze 4 und Substrat 1 bzw. Deckschicht 3.

Bevorzugt wird der Scannertisch 6 benutzt, um einen ersten Arbeitsabstand zwischen Spitze 4 und Deckschicht 3 einzustellen.

Ferner sind in Fig. 1 eine Steuer-und Regelungseinheit 7, sowie eine Stromquelle 8 mit einem Gleichstrom-und einem Wechselstromausgang 8a, 8b, schematisch angedeutet. In dem Ausleger 5 sind ein piezoresistiver Sensor 9 und ein Heizdrahtaktuator 10 eingebaut. Dem Heizdrahtaktuator 10 wird von dem Wechselstromausgang 8b der Stromquelle 8 ein Wechselstrom aufgeprägt, der ihn in periodische Schwingungen versetzt. Zusätzlich ist der Heizdrahtaktuator 10 an den Gleichstromausgang 8a angeschlossen. Wird dem Heizdrahtaktuator 10 ein Gleichstrom aufgeprägt, so biegt sich der Ausleger 5 in z-Richtung und nähert sich der Oberfläche 3a an. Dabei wird der dem Heizdrahtaktuator 10 zugeführte Gleichstrom so gewählt, dass sich der Ausleger 5 der Oberfläche 3a soweit annähert, dass van der Waals-Kräfte wirksam werden, was im non-contact-Modus eines AFM ausgenutzt wird. Die dadurch gedämpften Schwingungen des Auslegers 5 sind gegenüber der Anregungsfrequenz des Wechselstroms phasenverschoben. Die Phasenverschiebung zwischen dem Signal des Sensors 9 und des Wechselstroms der Stromquelle 8 wird einem Vergleicher 7a der Vergleichs-und Regelungseinheit 7 zugeführt. Der Regler 7b dieser Einheit 7 steuert den Gleichstromausgang 8a, um den Abstand von Ausleger 5 auf ein vorgegebenen Abstand einzustellen bzw. den Abstand konstant zu halten.

Auch andere Regelungsmechanismen wie zum Beispiel Contact-Mode und Intermediate Mode können angewandt werden. Des Weiteren kann man noch nach Amplitude (AM) und Frequenz (FM) regeln.

Zur genauen Beschreibung zur Einstellung und Steuerung des Abstands der Spitze 4 von dem Substrat 1 sowie zur Bewegung einer Auslegerspitze 4 in einem atomaren Kraftmikroskop wird u. a. auf die deutsche Patentanmeldung 103 07 561.5 verwiesen.

Es soll darauf hingewiesen werden, dass nicht nur ein Ausleger vorgesehen ist, sondern mehrere, bspw. 100 solcher Ausleger, die in einer Matrixanordnung angeordnet sind, bspw. wie in den Literaturstellen Rastersonden-Mikroskopie mit Cantilever-Arrays, Technisches Messen 73 (2006) 9, Pages 485-492
I.W. Rangelow at al. oder "Nanoprobe maskless lithography", Proc. SPIE-Int. Soc. Opt. Eng. 7637, 10pp (2010), Ivo W. Rangelow, Tzvetan Ivanov, Yanko Sarov, Andreas Schuh, Andreas Frank, Hans Hartmann, Jens-Peter Zöllner, Deirdre L. Olynick, V. Kalchenko; gezeigt ist. Dabei kann die Matrixanordnung eine Gesamtfläche von beispielsweise (und ohne jegliche Einschränkung) 10mm x 20mm einnehmen.

Eine solche Matrix nimmt etwa 1% der Nutzfläche eines sechs Zoll-Wafers ein, kann aber durch die x- und y-Bewegungen des Scannertisches verwendet werden, um mehrere Strukturen über die gesamte Nutzfläche des Wafers zu erzeugen. Der Gleichstromkreis und der Wechselstromkreis, die oben für einen einzelnen Ausleger beschrieben wurden, werden bei mehreren Auslegern entsprechend häufig benötigt, wie auch die entsprechende Steuerungen, wobei durch Multiplexverfahren die Anzahl der einzelnen Steuerungen herabgesetzt werden kann.

In einer bevorzugten Anordnung wird ein Wafer auf dem Scannertisch montiert und es wird auch eine Bewegung der Matrixanordnung der Ausleger 5 in einer X-, Y-Ebene durch einen piezoelektrischen Scanner bewirkt. Der die Matrixanordnung bewegende piezoelektrische Scannereinheit ist im Stande, die Matrixanordnung innerhalb eines kleinen rechteckigen Bereichs zu bewegen, während der den Wafer tragende Scannertisch im Stande ist, den Wafer relativ zu der Matrixanordnung zu bewegen, so dass die Matrixanordnung einzelne Matrixpunkte eines vorzugsweise quadratischen oder rechteckigen Rasters zu liegen kommt. Auf diese Weise können mehrere Bereiche des Wafers um jeden Matrixpunkt des Rasters jeweils mit der vorgesehenen Grobstruktur und der vorgesehenen Feinstruktur versehen werden, vor der Wafer in einzelnen Chips aufgeteilt wird, die demgemäß jeweils die vorgesehene Grob- und Feinstrukturen aufweisen.

In der Praxis werden alle Ausleger von einem entsprechend den herzustellenden Bauteilen bzw. dem durchzuführenden Lithographieverfahren und den zu realisierenden Ausrichtungs- bzw. Abbildungsaufgaben programmierten Rechner bzw. Mikroprozessor (FPGA) gesteuert, der auch die Steuerung der entsprechenden Stromkreise vornimmt. Dies bedeutet, dass die Steuerungen für die einzelnen Ausleger durch eine entsprechende Programmierung des Rechners bzw. des Mikroprozessors, d.h. der Steuerung, realisierbar sind. Die Steuerungsaufgaben umfassen die Aktuation und die Auslesung der Signale von den einzelnen Auslegern 5.

Auf der linken Seite der Fig. 1 ist eine strahlungsbasierte Lithographieeinrichtung 20 in einer rein schematischen Form gezeigt, die hier für Elekronenstrahllithographie ausgelegt ist, die bspw. in der JP-57059660B und JP1165561C beschrieben ist, die zu der sogenannten "In-Plane-Gate" Technologie geführt hat. Zum Beispiel kann ein Elektronenstrahlbelichtungssystem der Firma Raith in Dortmund Deutschland oder der Vistec in Jena eingesetzt werden.

Hier ist ein Elektronenstrahlerzeuger 22 vorgesehen, welcher elektromagnetische Spulen umfasst, die ausgelegt sind, um den Elektronenstrahl auf das Substrat zu fokussieren und in einer scannenden Bewegung über die Oberflache des Substrats 1 zu bewegen. Die fokussierende Wirkung ist schematisch als Linse 24 dargestellt. Anstelle der Bewegung des Elektronenstrahls könnte auch hier ein Scannertisch zur Anwendung gelangen, welcher das Substrat 1 bewegt. Dies ist allerdings in Hochvakuum eine schwierige Aufgabe, so dass die Bewegung des fokussierten Elektronenstrahls die bevorzugte Lösung ist. Auf jedem Fall wird das Substrat 1 in der strahlenbasierten Lithographieeinrichtung von einem Halter oder einem Tisch 6 gehalten. Hierbei ist das Substrat 1 das gleiche Substrat, wie es auf der rechten Seite in der Rastersondenlithographieeinrichtung 18 gezeigt ist. Die strahlenbasierte Lithographieeinrichtung befindet sich in einer Vakuumkammer 28 und es wird zwischen der Vakuumkammer 28 und dem, die Rastersondenlithographieeinrichtung 18 umfassenden Raum 30 eine Schleuse 32, durch die das Substrat 1 von einer Handhabungseinrichtung 34 in die Rastersondenlithographieeinrichtung 18 und/oder umgekehrt transferiert werden kann. Für die Handhabungseinrichtung 34 ist ein Roboter mit Greifer oder jede andere geeignete Art von Transfereinrichtung vorgesehen. Üblicherweise verfügt der Elektronenstrahlerzeuger über eine eigene Computersteuerung 36, die auch zur Steuerung der Handhabungseinrichtung 34 verwendet werden kann. Zum Schreiben von diskreten Strukturen kann der Elektronenstrahl nicht nur von der Computersteuerung kontrolliert bewegt (durch entsprechende Anregung der elektromagnetischen Spulen), sondern auch ein- und ausgeschaltet werden. All dies ist für sich gut bekannt.

Anstelle eines Elektronenstrahlerzeugers könnte ein Ionenstrahlerzeuger 22' verwendet werden, welcher auch schematisch in Fig. 1 eingezeichnet ist. Die Verwendung eines Ionenstrahlerzeugers ist beispielsweise in der EP 0 394 757 von Andreas Wieck und Klaus Ploog beschrieben, die zu der sogenannten "In plane gate" Technologie geführt hat.

Das heißt, die gleiche Zeichnung gilt sowohl für eine maskenlose Elektronenstrahllithographieeinrichtung als auch für eine maskenlose Ionenstrahllithographieeinrichtung. Ferner, könnte auch ein maskenbasierte Lithographieverfahren unter Anwendung jeglicher korpuskularer Strahlung (Elektronen, Ionen, Photonen) verwendet werden.

Zu diesem Zweck wird in Fig. 1 eine Maske 38 gezeigt, die bei Bedarf entsprechend dem Pfeil 40 vor dem Substrat 1 positioniert wird und dann mit tiefultraviolettem Licht (DUV) oder mit ultratiefviolettem Licht (EUV) oder mit Röntgenstrahlen beleuchtet wird, um die durch die Maske 38 vorgegeben Strukturierung auf die Resistschicht, auch Deckschicht genannt, zu transferieren. In diesem Fall ist die schematische Linse als eine Linse 24' oder Kollimator 24" ausgeführt, welche für einen ausgedehnten Belichtungsstrahl sorgt, um die Maske vollflächig zu bestrahlen. Eine solche Lithographieeinrichtung für die Grobstrukturierung kann ohne weiteres in der normalen Atmosphäre bzw. in einem Reinraum oder in einer Reinkammer verwendet werden, so dass eine Vakuumkammer überhaupt nicht erforderlich ist.

Die Bezugszeichen 22", 22"' und 22^{iv} zeigen, dass der Elektronenstrahlerzeuger 22 im Falle von einer maskenbasierten Lithographie als Erzeuger von tiefultraviolettem Licht (22"), ultratiefviolettem Licht (22'") oder von Röntgenstrahlen (22^{iv})ausgeführt ist.

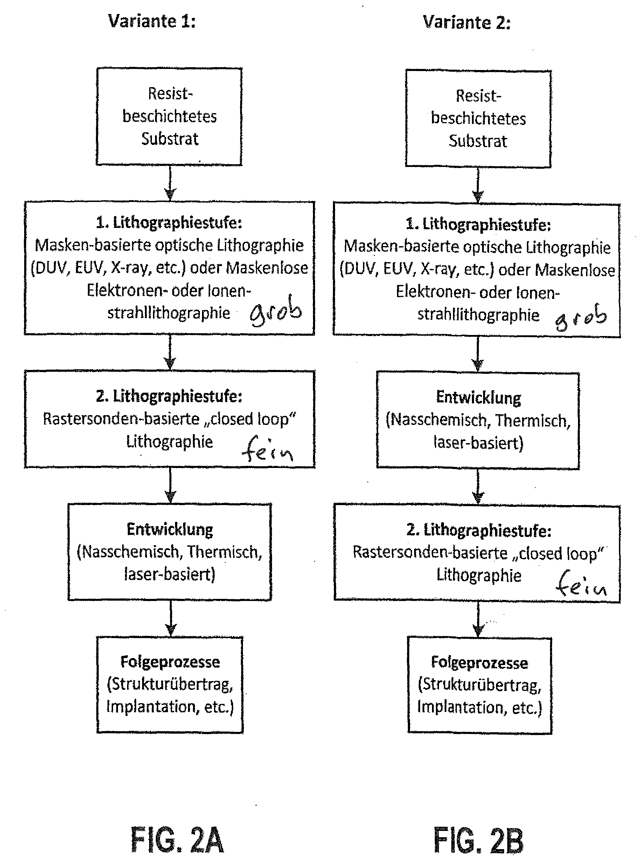

### Die Erfindung wird nachfolgend anhand von Beispielen näher erläutert unter Bezugnahme auf die Fig. 2A, 2B,, 4A, 4B, 5A, 5B, 6A, 6B, 7A, 7B, 8A und 8B.

### Beispiel 1: Herstellung eines SET durch Anwendung der beschriebenen MixundMatch Lithographiemethode entsprechend der Variante 2 gemäß Fig. 2B:

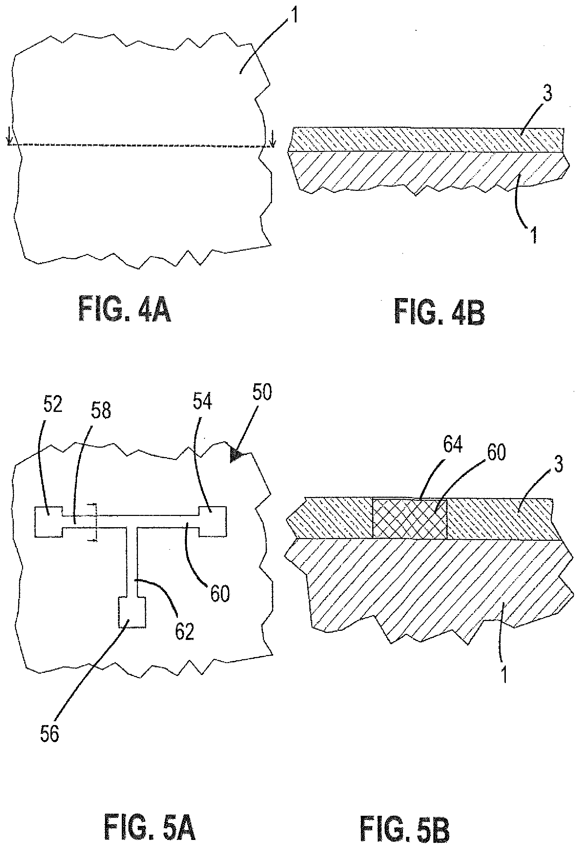

a) Als erster Schritt, der in Fig. 4A und 4B schematisch dargestellt ist, wird das Substrat 1 für die beschriebene Mix und Match Lithographiemethode durch Aufbringen einer Resistschicht 3, z. Bsp. durch Aufschleudern (Spin-Coating), Aufdampfen (PVD), durch das Langmuir-Blodgett Verfahren, als auch durch einen Selbstorganisationsprozess (Self-Assembly) oder durch ALD (atomare Schicht Abscheidung), usw., vorbereitet. Wie oben im Zusammenhang mit Fig. 1 beschrieben, kann die Resistschicht 3 auf ein beliebiges Substrat aufgebracht werden, welches auch bereits vorstrukturiert sein kann.

Je nach angewendeter Methode weisen die Resistfilme andere Eigenschaften bzgl. notwendiger Resist-Derivate, molekularer Organisation der Resistmoleküle und Kontrolle der Resistdicke und Oberflächenrauhigkeit des Resistfilms auf. Je nach verwendeter Methode müssen entsprechende spezifische Vor- oder Nachbehandlungen der Resistschicht durchgeführt werden.

Als Resistmaterial eignen sich zum Beispiel die Calixarene wie in den oben genannten Literaturstellen angegeben, insbesondere wurden die zwei gewerblich erhältlichen Calixarene Derivate für Lithographie verwendet, nämlich:
(a) C-methylcalix[4]resorcinarene (C-MC4R, C₃₂H₃₂O₈, Molekulargewicht: 544.59 g/mol), und
(b) 4-Methyl-1-acetoxycalix[6]arene (4M1AC6, C₆₀H₆₀O₁₂, Molekulargewicht: 973.14 g/mol).

Beide Derivate können mittels eines konventionellen Schleuderbeschichtungsverfahren (Spin-Coating Prozess) auf einer vorstrukturierten Substratoberfläche aufgebracht werden. Für das C-MC4R (4M1AC6) wurde die Schleuderbeschichtung bei 2000 U/min für 3 s plus 3000 (4000) U/min für 30 (45) s durchgeführt. Die Calixarene Lösungen wurden in Methyl-Isobutyl-Keton (MIBK, Sigma-Aldrich, HPLC Grade ≥ 99.5 %) Lösungsmittel für C-MC4R und in Monochlorobenzen (MCB, MERCK) für 4M1AC6 hergestellt. Unter Verwendung von 5.7 mmol/l C-MC4R Lösung (0.5% gew. 4M1AC6 Lösung) wurden ungefähr 10 nm Dicke Calixarene Resistschichten erzeugt. Das Material C-MC4R (4M1AC6) wurde anschließend durch eine Heizplatte bei 90 °C (175 °C) für 3 min (5 min) gebacken.

Vorzugsweise ist das Resistmaterial dadurch gekennzeichnet, dass dieses nicht aus Makromolekülen besteht, sondern aus Einzelmolekülen mit einer räumlichen Ausdehnung ≤ 2nm, welche in einem nicht-kettenförmigen Zustand, idealerweise nur durch nicht-kovalente chemische Bindungen, miteinander verbunden sind (intermolekulare Bindungen), und eine feste Deckschicht, auch Resistschicht genannt, ausbilden. Idealerweise bilden die einzelnen Resistmoleküle eine stabile (1-100nm Resistdicke) Resistschicht aus.

Gekennzeichnet sind die Resistmoleküle durch eine exakt definierte chemische Zusammensetzung, chemische Struktur, geometrische Ausdehnung und monodispersen, idealerweise minimalem Molekulargewicht. Beispiele für diese Klasse von Resistmaterialien sind neben Calixaren- und Resorcinaren-Derivaten, Fulleren-basierte Resiste und Derivate davon und andere molekulare Glasresiste.

### Ferner soll auf den Beitrag:

Single Component Molecular Glass Resists for EUVL: Richard Lawson (1), Robert Whetsell (2), Laren M. Tolbert (2), Clifford L. Hendersonl (1 School of Chemical und BiomolecularEngineering, 2 School of Chemistry and Biochemistry Georgia Institute of Technology), Wang Yueh (3), Jeanette Roberts (3) (3 Intel Corporation 2006), EUVL Symposium verwiesen werden, welcher hier relevante Informationen zu glassartigen Resisten enthält.

Alternativ können aber auch polymerbasierte Resistmaterialien, wie z. Bsp. PMMA, als auch spezielle Elektronenstrahl-spezifische organische und/oder anorganische Resiste wie z. Bsp. HSQ *(Hydrogen silsesquioxane)* eingesetzt werden. Alternativ können auch sogenannte hybride Resistmaterialien, welche sich aus organischen und anorganischen Komponenten zusammensetzen, wie z. Bsp. Au(I)-calix(4)aren diphosphin molekulare Komplexe oder Nanopartikel-Calixarene Komplexe, als auch chemisch verstärkte Resistmaterialien, auch CAR's genannt, eingesetzt werden.

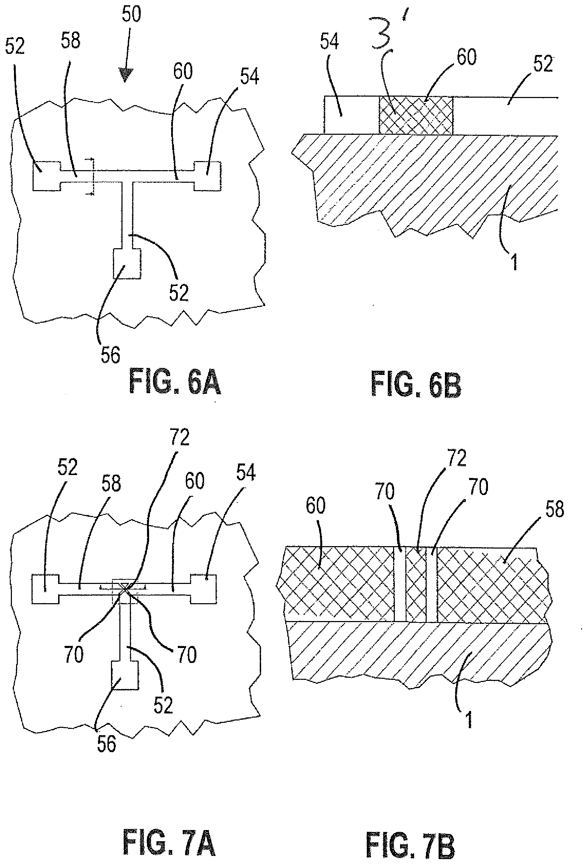

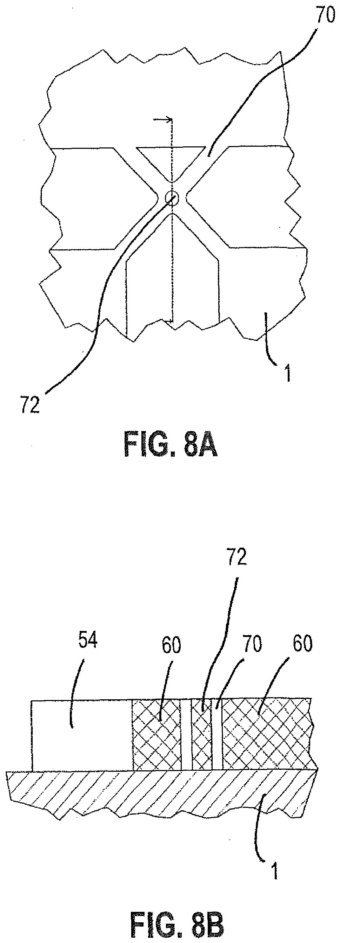

Je nach der Aufbringungsmethode des Resistmaterials 3 kann noch eine Nachbehandlung (z. Bsp. eine Wärmebehandlung, beispielsweise das sogenannte Tempern) erfolgen. Das Substrat 1 bzw. einen Ausschnitt davon ist den Fig. 4A und 4B zu entnehmen.
b) In einem ersten Lithographieschritt bzw. in einer ersten Lithographiestufe, (siehe Fig. 5A und 5B) erfolgt dann in diesem Beispiel zuerst die Bearbeitung der Nicht-CD-Strukturen, d.h. die Durchführung der Grobstrukturierung. Es werden die groben bzw. die unkritischen Strukturen 50 (Nicht-CD-Strukturen) mithilfe eines strahlenbasierten Lithographieverfahrens, zum Beispiel eines optischen Lithographieverfahrens (DUV, EUV, Röntgenstrahl usw.), oder eines Elektronenstrahl- oder eines Ionenstrahl-Lithographieverfahrens in dem Resist hergestellt. Somit werden die Bereiche 52, 54 und 56 für die Kontaktierung der Source-, Drain- und Gate-Bereiche 58, 60 bzw. 62 des Transistors durch Belichtung des Resists in diesen Bereichen (Positivverfahren) oder außerhalb dieser Bereiche (Negativverfahren) in der Resistschicht definiert.
   Das Resistmaterial der Resistschicht 3 ist idealerweise dadurch gekennzeichnet, dass die chemische Änderung, welche durch die einfallenden Photonen/Elektronen/Ionen der ersten Lithographiestufe, d.h. der Groblithographiestufe, ausgelöst wurden, bereits direkt nach der Lithographie mithilfe einer Rastersonde detektier- und erkennbar sind.
   Diese Eigenschaft ist vor allem dann wichtig, wenn direkt nach dem ersten Lithographieschritt b), d.h. der Grobstrukturierung des Resistes, ein zweiter Lithographieschritt, d.h. die Feinstrukturierung der groben Resiststruktur, welcher unter Anwendung einer Rastersonde als Lithographiewerkzeug stattfindet, folgt, ohne dazwischengeschalteten Entwicklungsschritt, wie in Variante 1 gemäß Fig. 2A dargestellt.
   Das heißt, dass hier die Rastersonde nicht nur als Lithographiewerkzeug betrieben wird, sondern auch als ein Positionierungswerkzeug analog des im europäischen Patents 1789853 beschriebenen Verfahrens, wobei die Spitze bzw. die Spitzen der Rastersonde sich entweder an Orientierungsmarken am Substrat oder beispielsweise an die Kanten orientieren, die aufgrund von Schrumpfung wie 64 bei der Vernetzung des Resistmaterials bei der groben Lithographiestufe entstehen.
   Im gezeigten Beispiel wird die Resistschicht 3 durch einfallende Photonen/Elektronen/Ionen lokal vernetzt, wodurch die lokale Löslichkeit in einem flüssigen Entwickler herabgesetzt wird (Negativresist). Durch diesen Erkennungsschritt, der sowohl vor als auch nach dem Entwicklungsschritt gemäß Abschnitt c) durchgeführt werden kann (oder nach diesem Entwicklungsschritt wiederholt werden kann), kann geprüft werden, dass die grobe Strukturierung erfolgreich durchgeführt wurde. Gegebenenfalls kann mittels der Rastersonde die grobe Strukturierung auch korrigiert werden, beispielsweise in dem Sinne, dass überstehende zu groß gewordene Bereiche der belichteten Resistschicht weggeschnitten werden, d.h. die grobe Resiststruktur wird mithilfe einer Feinstrukturierung, durchgeführt durch die Rastersonden-basierte Lithographie, ergänzt
c) Das Resistmaterial wird in diesem Beispiel anschließend entwickelt, beispielsweise unter Anwendung an sich bekannter Verfahren wie nasschemische, thermische, laser-basierte oder Trockenentwicklungs-Verfahren. Wie in den Fig. 6A und 6B gezeigt, bleibt nur das vernetzte Resistmaterial 3' stehen, während das nicht-vernetzte Resistmaterial 3 (Fig. 5B) durch den flüssigen Entwickler abtransportiert wird.
d) Es wird dann ein zweiter Lithographieschritt bzw. eine zweite Lithographiestufe zur Erzeugung der kritischen (CD-) Strukturen, d.h. die Feinstrukturierung mit nanometer-genauem Alignment (Ausrichtung) unter Einsatz der zuvor beschriebenen Rastersonden-basierten Lithographiemethode durchgeführt. Das Ergebnis dieses zweiten Lithographieschrittes ist der Fig. 7A und 7B und zu einem größeren Maßstab den Fig. 8A und 8B zu entnehmen.
   In den Fig. 7A und 7B bzw. Fig. 8A und 8B ist nun ein x-förmiger Kanalbereich 70 mit Querabmessungen in der Größenordnung von ca. 1 nm zu sehen. Mitten in der x-förmigen Kanalbereich befindet sich ein in Draufsicht kreisförmiger Bereich 72, welcher später eine Quanteninsel für Elektronen bilden wird.
   D.h. die Rastersonde wird erst relativ zum Substrat oder zu der darauf erzeugten Strukturierung - wie oben nach b) erläutert, orientiert. Der Einsatz der beschriebenen Rastersondenlithographie macht es dann möglich, bei entsprechender Ansteuerung und Bewegung bzw. Positionierung der Rastersonde 22 oder eines das Substrat tragenden Tisches 26, die bereits in einer ersten Lithographiestufe (Grobstrukturierung) veränderten Resistschicht 3 nochmals mithilfe der Rastersonde lokal zu modifizieren oder lokal zu entfernen (Feinstrukturierung). Die Struktur, die durch die Rastersondenlithographieeinrichtung 18 in den Fig. 7A, 7B, 8A und 8B erzeugt wird, stammt in diesem Beispiel von einem einzigen Ausleger 5 mit einer Spitze 4. Je nach den geometrischen Verhältnissen können weitere Ausleger oder einige davon, angeordnet typischerweise in einer Matrixanordnung, zur Erzeugung von weiteren Feinstrukturierungen bei weiteren Transistoren eingesetzt werden.
   Ferner wäre es auch möglich mehrere verschieden spezialisierte Rastersonden, zum Beispiel Rastersonden für die Lithographie und Rastersonden für die Abbildung, in einer Matrixanordnung vorzusehen. So könnte die Rastersonde für die Lithographie derart ausgeführt sein, das diese ideale Ergebnisse, d.h. höchste lithographische Auflösung, erzielt, wobei die Rastersonde für die Abbildung entsprechend so ausgelegt ist, das diese ideale Ergebnisse für die Abbildung der Nanostrukturen erlaubt.
   Ggf. muss der Tisch 6 nicht nur während des Schreibens einer einzelnen Feinstruktur bei einem Transistor durch einen Ausleger 5 mit Spitze 4 bewegt werden, sondern auch zwischen dem Schreiben der Feinstruktur bei weiteren Transistoren.
   Dabei kann man die geschlossene Schleife zwischen Abbilden und Strukturieren der Rastersondenlithographie, d.h ohne eines dazwischen angeordneten Schrittes (wie Entwicklung) für die Inspektion als auch für das Alignment der Strukturen ausnutzen.
   Zur Erzeugung der funktionsentscheidenden Feinstrukturen bietet die beschriebene Rastersonden-lithographische Methode den Vorteil einer geschlossenen Schleife zwischen Abbildung und Strukturierung mit derselben Vorrichtung. Dies bedeutet, dass man mit ein und derselben Vorrichtung, ohne Wechsel der Rastersonde bzw. des Werkzeuges, und in-situ sowohl die Strukturen abbilden als auch bearbeiten bzw. Lithographie betreiben kann. Dies ermöglicht es mit ein und demselben Werkzeug in serieller, oder paralleler Weise bei Anwendung eines Arrays aus Rastersonden, die Grobstrukturen zunächst abzubilden und diese lokal mit der Rastersonde zu analysieren, wobei im nachfolgenden die Position der Feinstrukturen innerhalb der Grobstrukturen exakt bestimmt und festgelegt wird. Unter Anwendung der vorangegangen Abbildung kann die Feinstruktur mithilfe der Rastersonde lokal exakt positioniert geschrieben werden und direkt danach, in-situ, nur durch Änderung von Parametern mithilfe des gleichen Werkzeuges bzw. Rastersonde wieder zur Kontrolle und Analyse der Strukturabmessungen und Position der funktionsentscheidenden Feinstruktur abgebildet werden. Unter Umständen, bei Auftreten von Fehlern von Größe und/oder Position der Feinstruktur kann nochmals unter Anwendung der Rastersonden-basierten Feinstrukturierungsmetode die Resist-Feinstruktur modifiziert werden, um so zum Beispiel die entsprechende Feinstruktur zu reparieren. So können bereits bei der Definition der wichtigsten funktionellen Strukturen von Nano-Bauelementen deren Funktion durch in-situ Abbildung, Overlay Alignment, Kontrolle und u.U. Reparatur der Feinstrukturen sichergestellt werden. Die geschlossene Schleife beschreibt dabei das direkte aufeinanderfolgen von "Abbildung (Kontrolle) - Lithographie - Abbildung (Kontrolle) - usw.", dass ohne Wechsel der Vorrichtung und ggbfs. des Werkzeuges erfolgt, was eine in-situ Kontrolle als auch eine extrem exakte Positionierung jeder einzelnen Lithographiestruktur ermöglicht. Dieses Prinzip einer direkten Abfolge von Abbildung und Lithographie kann auch als eine Art geschlossene Regelschleife verstanden werden, da die in-situ Abbildung wiederum zur Anpassung der Position und Strukturabmessung der lithographischen Zielstruktur herangezogen wird.
   Diese Methodik einer geschlossenen Lithographieschleife erlaubt nach vorangegangenem Abbilden des Interessenbereiches:
   - die exakte Analyse und Inspektion der Vorstruktur,
   - die Ausrichtung und das Alignment der lithographischen Zielstruktur (welche mit dem Rastersonden-basierten Verfahren geschrieben werden soll) auf die bereits vorhandenen Strukturen,
   - das Schreiben der Zielstruktur unter Anwendung der beschriebenen astersondenlithographie und
   - der nachfolgenden Abbildung und Inspektion der geschriebenen Strukturkombination unter Anwendung derselben Vorrichtung für alle einzelnen Prozessschritte.
e) Das erfindungsgemäße Lithographieverfahren kann anschließend von beliebigen Folgeprozessen gefolgt werden, wie z. Bsp. Strukturübertrag in das darunterliegende Substrat, z. Bsp. durch nasschemische Ätzverfahren und Trockenätzverfahren, oder Abscheidung von Strukturen auf das darunterliegende Substrat, durch z. Bsp. Lift-Off-Techniken. Ferner kann eine Weiterverarbeitung auch durch Implantationsverfahren, Metallisierung, usw. erfolgen.

### Beispiel 2: Herstellung eines SET durch Anwendung der beschriebenen MixundMatch Lithographiemethode entsprechend der Variante 1 gemäß Fig. 2A:

Dieses Herstellungsverfahren läuft im Prinzip ganz ähnlich ab wie das Verfahren gemäß Beispiel 1, jedoch wird hier der Entwicklungsschritt c) nicht sofort nach dem ersten Lithographieschritt b) der Grobstrukturierung durchgeführt, sondern erfolgt erst nach dem zweiten Lithographieschritt (-Abschnitt d) der Feinstrukturierung, welche unter Anwendung der Rastersondenlithographie durchgeführt wird.

Dabei muss das Resistmaterial der Resistschicht 3 dadurch gekennzeichnet sein, dass die chemische Änderung, welche durch die einfallenden Photonen/Elektronen/Ionen der ersten Lithographiestufe b), der Grobstrukturierung ausgelöst wurden, bereits direkt nach der Lithographie mithilfe einer Rastersonde detektier- und erkennbar sind. Diese Eigenschaft ist vor allem dann wichtig, wenn direkt nach der Grobstrukturierung ein zweiter Lithographieschritt, die Feinstrukturierung, folgt, welcher unter Anwendung einer Rastersonde als Lithographiewerkzeug stattfindet, ohne einen dazwischengeschalteten Entwicklungsschritt, wie in Variante 1 gemäß Fig. 2A dargestellt. Das heißt, dass hier die Rastersonde nicht nur als Lithographiewerkzeug betrieben wird, sondern auch als ein Positionierungswerkzeug analog des im europäischen Patents 1789853 beschriebenen Verfahrens, wobei die Spitze der Rastersonde sich entweder an Orientierungsmarken am Substrat oder beispielsweise an die Kanten orientieren, die aufgrund von Schrumpfung, wie 64 bei der Vernetzung des Resistmaterials entstehen. Im gezeigten Beispiel wird die Resistschicht 3 durch einfallende Photonen/Elektronen/Ionen lokal vernetzt, wodurch die lokale Löslichkeit in einem flüssigen Entwickler herabgesetzt wird (Negativresist). Durch diesen Erkennungsschritt, der auch erst nach dem Entwicklungsschritt durchgeführt werden kann, kann geprüft werden, dass die Grobstrukturierung erfolgreich durchgeführt wurde. Ggf. kann mittels der Rastersonde die Grobstrukturierung auch korrigiert werden, beispielsweise in dem Sinne, dass überstehende zu groß gewordene Bereiche der belichteten Resistschicht weggeschnitten werden oder zu kleine Bereiche unter Anwendung der Rastersonde nachbelichtet werden, bis die gewünschte Zielstruktur erreicht ist.

Das Ergebnis sieht genauso aus wie in den Fig. 7A, 7B und 8A, 8B gezeigt, der Unterschied besteht im Wesentlichen nur darin, dass bei der Variante 1 gemäß Fig. 2A, beschrieben im Beispiel 2, das Resistmaterial im Kanalbereich 70 des SET's, d.h. im Bereich des engen Kanals, der eine Feinstruktur darstellt, bereits vor dem Entwicklungsschritt mithilfe des Rastersonden-basierten Lithographieschrittes, lokal bearbeitet bzw. lokal entfernt wird. Hingegen bei Variante 2 gemäß Fig. 2B, beschrieben im Beispiel 1, findet direkt nach der ersten Lithographiestufe, d. h. der Grobstrukturierung, ein Entwicklungsschritt statt, und erst nachfolgend die Feinstrukturierung , in welcher eine Entfernung des Resistmaterials im Kanalbereich 70 des SET's unter Anwendung der Rastersonde erfolgt.

Das bisherige Verfahren liefert keine fertigen SET's, um dies zu erreichen sind mehrere weiter Prozessschritten erforderlich. Ausgehend von der Struktur gemäß den Fig. 6A und 6B bzw. 7A und 7B sind dies im Wesentlichen wie folgt aufzulisten: 1-Möglichkeit: Metalabscheidung mittels "Atomic layer deposition" (2-3nm) und Trockenätzen; 2-Möglichkeit: selektives "Atomic layer deposition"; oder 3-Möglichkeit: Lift-Off Prozess.

Mit anderen Wörtern beschrieben liefert das bisherige Verfahren keine fertigen SET's, sondern im wesentlichen eine entsprechende Abbildung von Grob- und Feinstrukturen im selbem Bereich in ein und derselben Resistschicht, d.h. die groben Resiststrukturen sind mit einer feinen Resiststruktur, durchgeführt in einer zweiten Lithographiestufe, welche entweder vor als auch nach dem Entwicklungsschritt erfolgen kann, ergänzt worden. Um fertige SET's zu erreichen, sind weitere Prozessschritte erforderlich, die für jedes nanoelektronische Bauteil beliebig ausfallen können, wie zum Beispiel Strukturübertrag in das darunterliegende Substrat, z. Bsp. durch nasschemische Ätzverfahren oder Trockenätzverfahren, oder Abscheidung von Strukturen auf das darunterliegende Substrat durch z. Bsp. Lift-Off-Techniken. Ferner kann eine Weiterverarbeitung auch durch Implantationsverfahren, Metallisierung, usw. erfolgen. Ausgehend von der Struktur gemäß den Fig. 7A und 7B bzw. 8A und 8B sind dies im Wesentlichen beispielsweise:
- Strukturübertrag durch idealerweise Trockenätzverfahren in das darunterliegende Substrat, welches idealerweise einen SOI-Wafer mit ultra-dünner Top-Silizium-Schicht (<20nm) darstellt. Der Strukturübertrag erfolgt bis auf die vergrabene Oxidschicht des SOI-Wafers, womit direkt eine SET-Struktur definiert wird.
- Herstellung der Kontakte nach außen durch entsprechenden nachfolgenden Lithographieschritt mit Strukturübertrag durch Lift-Off Techniken oder anderen Abscheidetechniken.
- Abscheidung einer Isolationsschicht oberhalb des SETs zur Passivierung.
- Je nach nanoelektronischen oder NEMS Bauteil und Erfordernissen kann die Kette von Folgeprozessen variieren.

Die Herstellung eines SET stellt jedoch nur eines von unzählig vielen Beispielen zur Anwendung der beschriebenen Lithographiemethode dar. Normalerweise wird nicht ein SET, sondern eine große Zahl von in einer Matrix angeordneten SETs hergestellt, die aneinander, je nach konkreter Anwendung, angeschlossen werden können. Die Varianten 1 und 2 zeigen jedoch die Grundzüge, wonach allerlei, an sich bekannter Bauteile auf Substraten bzw. Chips gefertigt werden können, jedoch mit Abmessungen im feinstruktur-Bereich von einem oder wenigen Nanometern. Der Vorteil liegt bei der Anwendung dieser Methodik darin, dass nicht die gesamte Resiststruktur durch Anwendung der Feinstruktur-Lithographie definiert werden muss, was extrem zeitintensiv ist, sondern das die Feinstruktur-Lithographie dazu dient, die Grobresiststrukturen, definiert in einer vorangegangenen Grobstruktur-Lithographiemethode, zu modifizieren, so das der Gesamtdurchsatz der Lithographie nicht maßgeblich verringert wird, jedoch ein großer Resist-Strukturbereich von mehreren hundert Mikrometern bis zum Einzelnanometerbereich durch eine einzelne Prozessstufe abgedeckt werden kann. Der hier beschriebene erfindungsgemäße Vorschlag eröffnet vielfältige Design- und Kombinationsmöglichkeiten einer Mix und Match (hybriden) Lithographiemethode zur Herstellung von nanoelektronischen und nanoelektromechanischen Bauelementen.

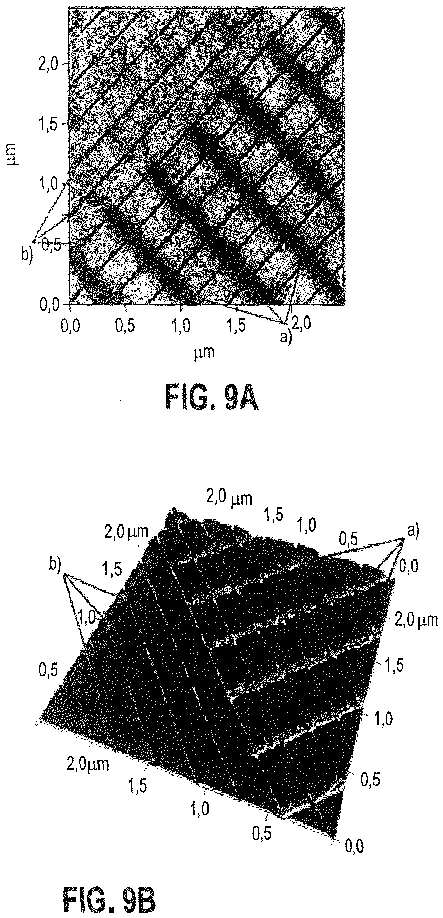

Zur Darlegung der Machbarkeit bzw. Realisierbarkeit des erfindungsgemäßen Verfahrens wird auch auf die Fig. 9A und 9B verwiesen, die AFM-Topographiebilder nach Anwendung der beschriebenen Lithographiemethoden zeigen. Die Fig. 9A entspricht einer zwei-dimensionalen Darstellung der Oberflächentopographie, während die Fig. 9B eine perspektivische Darstellung zeigt, die gegenüber der Fig. 9A um etwa 90° gedreht ist. In diesen AFM-Topographiebildern bedeuten a) die Grobstrukturen, die (in diesem konkreten Fall) mit Elektronenstrahllithographie erzeugt wurden, während b) die Feinstrukturen zeigt , die mittels der Rastersondenlithographie erzeugt wurden. Aus diesen zwei AFM-Bildern geht nicht nur die Größe der erreichbaren Strukturen hervor, sondern sie liefern den Beweis dafür, dass das notwendige Alignment (Ausrichtung) der zwei Lithographiestufen erreicht werden kann.

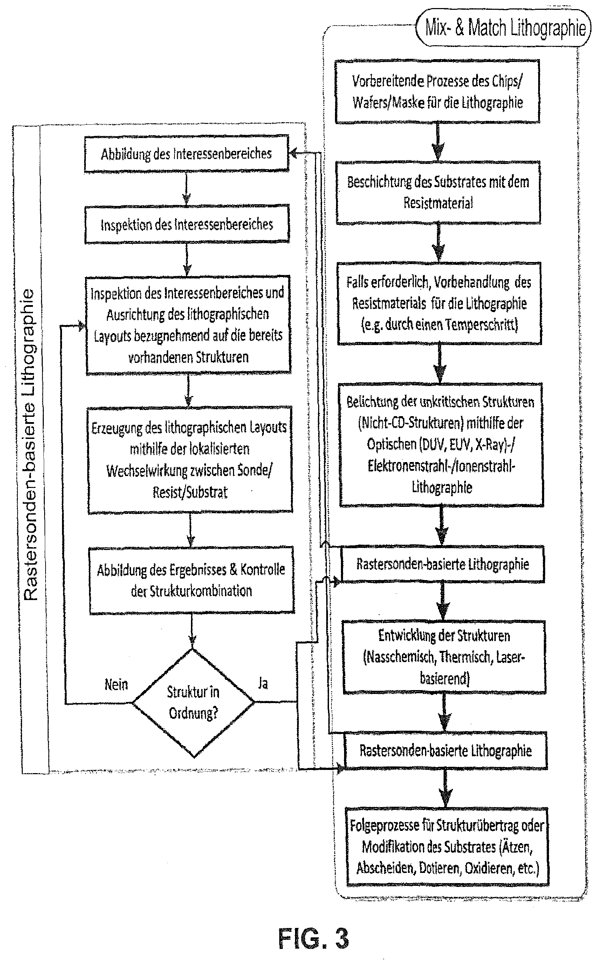

In der Fig. 3 wird ein allgemeingültiges Flussdiagram gezeigt, dass mögliche Abläufe des erfindungsgemäßen Verfahrens zeigt und hiermit auch die besondere Flexibilität des Verfahrens dokumentiert.

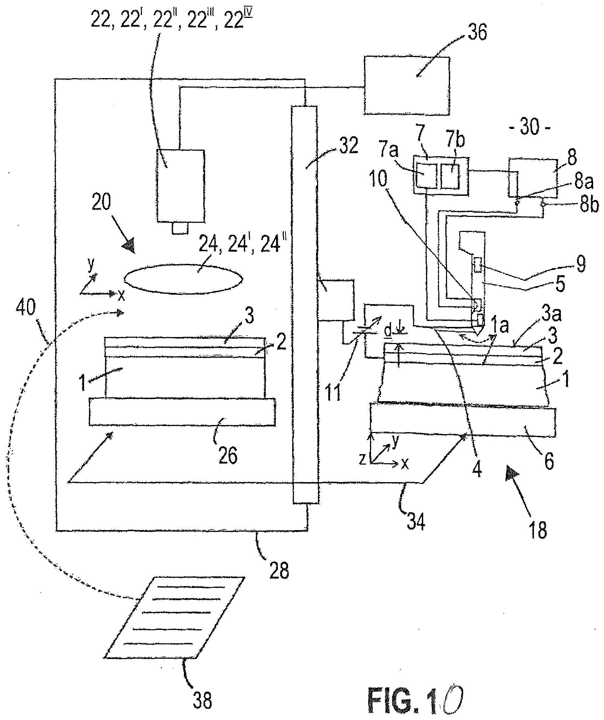

Vorzugsweise ist das Rastersonden-basierte Abbildungs- und Lithographiesystem so ausgeführt, dass der Winkel zwischen dem Substrat und dem Ausleger 5, auch Cantilever genannt, variierbar ist. Somit ist es möglich, die Rastersonde sowohl im konventionellen dynamischen Modus (10-12° Winkel zwischen Substrat und Cantilever) als auch im sogenannten Shear-Force Modus bei einem 90° Winkel zwischen Substrat und Cantilever zu betreiben. Dabei wird der vorher genannte konventionelle Modus dadurch gekennzeichnet, dass die am Ende des Auslegers 5 (Cantilever) angeordnete Spitze 4 (auch Tip genannt) nahezu vertikal zur Substratoberfläche oszilliert, je nach voreingestellten Winkel, typischerweise zwischen 10° und 12°, während der Ausleger 5 im sogenannten Shear-Force Betrieb nahezu horizontal (ohne vertikale Oszillation) zur Bezugsebene der Substratoberfläche oszilliert. Diese horizontale Oszillation (mit senkrechter Ausrichtung des Auslegers 5) ist in der Fig. 10 mit dem Doppelpfeil dargestellt, die der Fig. 1 sehr ähnlich ist. Die Beschreibung die bisher für die Fig. 1 anhand der dort verwendeten Bezugszeichen gilt genauso für Ausführung gemäß Fig. 10, bei der die gleichen Bezugszeichen verwendet werden und die gleiche Bedeutung haben.

Der zum Substrat horizontale Schwingungsmodus (Shear Force) bietet gegenüber dem vertikalen Schwingungsmodus in der Anwendung als Closed-loop Lithographiesystem die Vorteile:
(a) dass nur eine minimale Abstandsvariation zwischen Probenoberfläche und Nanospitze (welche sich am Ende des Cantilevers befindet), vorhanden ist;
(b) Minimierung des parasitären elektrostatischen Aktuator-Effektes des Biegebalkens bei Anlegung einer Potentialdifferenz zwischen Cantilever und Substrat, welche im vertikalen Oszillationsmodus durch die annähernd parallele Anordnung von Cantilever und Substrat begünstigt wird;
(c) Minimierung der parasitären Kapazität zwischen Cantilever und Substrat bei Anlegung einer Potentialdifferenz zwischen Cantilever und Substrat, welche im vertikalen Oszillationsmodus durch die annähernd parallele Anordnung von Cantilever und Substrat begünstigt wird.

Diese Vorteile prädestinieren den Shear Force Anordnung für die Anwendung mit einer variablen/modulierbaren Potentialdifferenz, welche zwischen Spitze und Probe angelegt wird.

Ferner kann der Winkel zwischen Substrat und Cantilever frei einstellbar sein, ohne dass ein aufwendiger Umbau des Abbildungs- und Lithographiesystem notwendig ist. So können beliebige Zwischenstufen zwischen Normalanordnung und Shear-Force-Anordnung vorhanden sein.

Die verwendete Rastersonde für die Rastersonden-basierte Lithographiestufe kann dabei als State-of-the-art Cantilever als auch als piezoresistiver, selbst-aktuierter Cantilever ausgeführt sein.

Anzumerken ist, dass die horizontale Oszillation (wie bei dem vorher beschriebenen Cantilevern realisiert) mithilfe der Heizmäander auf dem Cantilever, welche eine bimorph-Struktur mit dem darunterliegenden Biegebalken ausbildet. Vereinfacht gesagt wird der Cantilever nur um 90° gedreht. Aufgrund der integrierten Aktuation und piezoresistiven Sensoren sind keine weiteren Anpassungsschritte notwendig, um den Cantilever im Shear Force Modus zu betreiben. Die einzige Besonderheit besteht darin, die Spitze in-plane, also in der Ebene des Cantilevers, zu definieren. Dies ist in der Fig. 14 durch den Doppelpfeil entsprechend dargestellt, um die horizontale Oszillation zu verdeutlichen.

## Patentansprüche

1. Lithographieverfahren, bei dem ein von einer Rastersonde erzeugtes elektrisches Feld und ein daraus resultierender Feldemissions-, Tunnel- oder Faraday'scher-Elektronenstrom zur Erzeugung einer Feinstrukturierung einer Resistschicht (3) verwendet wird, wobei vor der Feinstrukturierung eine Grobstrukturierung derselben Resistschicht (3) mittels einer strahlenbasierten Lithographiemethode durchgeführt wird, wobei die Grobstrukturierung und die Feinstrukturierung direkt im selben Lithographiebereich bzw. überlappend erzeugt werden,
wobei in einem vorbereitenden Schritt ein Substrat (1) mit dem Resist (3) beschichtet wird, das beschichtete Substrat mittels einer maskenbasierten optischen Lithographie oder einer maskenlosen Elektronen- oder Ionenstrahllithographie behandelt wird, in einem weiteren Behandlungsschritt ein Entwicklungsverfahren durchgeführt wird und in einem nachfolgenden Lithographieschritt der nach der Entwicklung noch verbleibende Resist mittels einer auf der Rastersonde basierten closed loop Lithographie lokal entfernt wird.

2. Lithographieverfahren nach dem Anspruch 1, **dadurch gekennzeichnet, dass** die Rastersonde dazu verwendet wird, die genaue Position der Grobstrukturierung vor der Durchführung der Feinstrukturierung zu ermitteln.

3. Lithographieverfahren nach Anspruch 1 oder 2, **dadurch gekennzeichnet, dass** die strahlenbasierte Lithographiemethode aus der Gruppe, bestehend aus Elektronenstrahllithographie, Ionenstrahllithographie und maskenbasierte DUV-, EUV- oder Röntgenstrahl-Lithographie, gewählt wird.

4. Lithographieverfahren nach einem der vorhergehenden Ansprüche, **dadurch gekennzeichnet, dass** das Entwicklungsverfahren ein nasschemisches, thermisches oder laserbasiertes Entwicklungsverfahren ist.

5. Lithographieverfahren nach einem der vorhergehenden Ansprüche 1 bis 3, **dadurch gekennzeichnet, dass** das Substrat (1) anschließend mit Folgeprozessen wie Strukturübertrag, Lift-Off, Implantation oder Metallisierung ALD weiterverarbeitet wird.

6. Lithographieverfahren nach einem der vorhergehenden Ansprüche, **dadurch gekennzeichnet, dass** das Resistmaterial der Resistschicht (3) aus der folgenden Gruppe ausgewählt wird:
- Calixaren und/oder Resorcinaren Derivate, wie C-methylcalix[4]resorcinaren, oder 4-Methyl-1-acetoxycalix[6]aren oder Derivate von Calixarenen und Resorcinarenen, welche auch für Langmuir-Blodgett, Self-Assembly oder Aufdampf- Schichtpräparationstechniken entsprechend chemisch funktionalisiert sind;
- Resistmaterial, das nicht aus Makromolekülen und/oder Kettenmolekülen besteht, sondern aus Einzelmolekülen mit einer räumlichen Ausdehnung ≤ 2nm, welche in einem nicht-kettenförmigen Zustand, nur durch nicht-kovalente Bindungen miteinander verbunden sind, und eine feste Resistschicht von 1 bis 100 nm ausbilden, wobei sich die Resistmoleküle durch eine exakt definierte chemische Zusammensetzung, chemische Struktur, geometrische Ausdehnung und monodisperses minimales Molekulargewicht auszeichnen, zum Beispiel Fulleren-basierte Resistmaterialien und Derivate davon und andere molekulare Glasresistmaterialien;
- sogenannte hybride Materialien, welche sich aus organischen und anorganischen Komponenten zusammensetzen, wie Au(I)-calix(4)aren diphosphin molekulare Komplexe oder Nanopartikel-Calixarene Komplexe;
- chemisch verstärkte Resistmaterialien;
- polymerbasierte Resistmaterialien wie PMMA;
- spezielle Elektronenstrahl-sezifische organische und/oder anorganische Resistmaterialien, wie HSQ.

7. Lithographieverfahren nach einem der vorhergehenden Ansprüche 1 bis 6, wobei entweder
der nach der Entwicklung noch verbleibende Resist durch die Grobstrukturierung vernetzt wurde und der durch die Feinstrukturierung nicht entfernte Resist unter Anwendung derselben Rastersondenlithographieeinrichtung (18) im Sinne einer weiteren Feinstrukturierung lokalisiert entfernt oder lokalisiert stehengelassen wird,
oder
der nach der Entwicklung noch verbleibende Resist durch die Grobstrukturierung nichtvernetzt ist und der durch die Feinstrukturierung nicht entfernte Resist unter Anwendung derselben Rastersondenlithographieeinrichtung (18) im Sinne einer weiteren Feinstrukturierung lokalisiert vernetzt wird..

8. Lithographieverfahren nach Anspruch 7, **dadurch gekennzeichnet, dass** durch Auswahl eines Parametersatzes für die Rastersonde, bestehend aus elektrischer Potentialdifferenz, Elektronendosis, welche sich aus dem Stromwert und Schreibgeschwindigkeit der Rastersonde zusammensetzt, Umgebungsbedingungen und Umgebungsparameter, wie zum Beispiel die umgebende Gase und deren Partialdruck, die herrschende Temperatur oder die Luftfeuchtigkeit die Spitze (4) der Rastersonde, das Resistmaterial (3) und der Abstand zwischen der Spitze (4) und der Resistschicht (3), verschiedene Wechselwirkungsmechanismen zwischen Spitze und Resistschicht eingestellt werden, welche sich durch eine lokale chemische Modifikation des Resistmaterials oder eine lokale Entfernung des Resistmaterials oder beides äußern.

9. Lithographieverfahren nach Anspruch 7 oder 8, **dadurch gekennzeichnet, dass** durch die Kombination von Vernetzung und lokaler Entfernung von Resistmaterial eine Strukturierung ermöglicht wird, was ein Erzeugen von Strukturen mithilfe von Positiv-Resist-Verhalten oder Negativ-Resist-Verhalten oder beides in Kombination ermöglicht.

10. Lithographieverfahren nach einem der vorhergehenden Ansprüche 7 - 9, **dadurch gekennzeichnet, dass** die Rastersondenlithographieeinrichtung (18) so ausgeführt wird, dass der Winkel zwischen dem Substrat (1) und dem Ausleger (5) variierbar ist, wodurch es möglich wird, die Rastersondenlithographieeinrichtung sowohl im konventionellen dynamischen Modus bei einem Winkel zwischen 10° und 12° zwischen Substrat und Ausleger als auch im sogenannten Shear-Force Modus bei einem 90° Winkel zwischen Substrat und Ausleger zu betreiben, wodurch der dynamische Mode sich dadurch auszeichnet, dass die am Ende des Auslegers angeordnete Spitze (4) nahezu senkrecht zur Substratoberfläche oszilliert, je nach voreingestellten Winkel, während im sogenannten Shear-Force Betrieb der Ausleger (5) nahezu parallel mit nur minimalem vertikalem Oszillationsanteil zur Bezugsebene der Substratoberfläche oszilliert.

11. Lithographievorrichtung bestehend aus
- einer Lithographieeinrichtung (20), die ausgelegt ist, um eine grobe Strukturierung einer auf einem Substrat (1) vorhandenen Resistschicht (3) vorzunehmen,
- einer Rastersondenlithographieeinrichtung, um nach der Grobstrukturierung eine Feinstrukturierung derselben Resistschicht (3), direkt im selben Lithographiebereich bzw. überlappend vorzunehmen, wobei die Rastersondenlithographieeinrichtung ausgestattet ist mit mehreren in einer Matrix angeordneten, gesteuert ablenkbaren Auslegern (5), die jeweils eine Spitze (4) aufweisen, mit einer Scannereinrichtung um eine relative Scanbewegung der Matrixanordnung der Ausleger (5) relativ zu einem das Substrat (1) tragenden Halter bzw. Tisch (6) vorzunehmen und mit einer Einrichtung um den Abstand zwischen den Spitzen der Ausleger und der Substratoberfläche einzustellen, sowie
- einer der Rastersondenlithographieeinrichtung zugeordneten Ausrichteinrichtung, die zur Ausrichtung der Rastersondenlithographieeinrichtung in Bezug auf ein vorstrukturiertes Substrat oder eine grobstrukturierte Resistschicht ausgelegt ist,
wobei die Lithographievorrichtung eingerichtet ist, in einem vorbereitenden Schritt ein Substrat (1) mit dem Resist (3) zu beschichten, das beschichtete Substrat mittels einer maskenbasierten optischen Lithographie oder einer maskenlosen Elektronen- oder Ionenstrahllithographie zu behandeln, in einem weiteren Behandlungsschritt ein Entwicklungsverfahren durchzuführen und in einem nachfolgenden Lithographieschritt den nach der Entwicklung noch verbleibenden Resist mittels einer Rastersonden-basierten closed loop Lithographie lokal zu entfernen.

12. Lithographievorrichtung nach Anspruch 11, **dadurch gekennzeichnet, dass** die strahlenbasierte Lithographieeinrichtung (20) zur Durchführung eines maskenbasierten DUV-, EUV- oder Röntgenstrahlen-Lithographieverfahrens, ausgelegt ist.

## Claims

1. A lithography method in which an electric field generated by a scanning probe and a field emission current, tunnel current or Faraday electron current resulting therefrom is used to generate a fine structuring of a resist layer (3), wherein a rough structuring of the same resist layer (3) is carried out by means of a beam-based lithography method prior to the fine structuring, with the rough structuring and the fine structuring being generated directly in the same lithography region or in an overlapping manner, and
wherein a substrate (1) is coated with the resist (3) in a preparatory step; the coated substrate is treated by means of a mask-based optical lithography or a maskless electron beam lithography or ion beam lithography; a development process is carried out in a further treatment step; and the resist still remaining after the development is locally removed in a subsequent lithography step by means of a closed loop lithography based on the scanning probe.

2. A lithography method in accordance with claim 1, **characterized in that** the scanning probe is used to determine the exact position of the rough structuring before the performance of the fine structuring.

3. A lithography method in accordance with claim 1 or claim 2, **characterized in that** the beam-based lithography method is selected from the group comprising electron beam lithography, ion beam lithography and mask-based DUV lithography, EUV lithography or X-ray lithography.

4. A lithography method in accordance with any one of the preceding claims, **characterized in that** the development process is a wet chemical development process, a thermal development process or a laser-based development process.

5. A lithography method in accordance with any one of the preceding claims 1 to 3, **characterized in that** the substrate (1) is subsequently further processed by subsequent processes such as structure transfer, lift-off, implantation or ALD metallization.

6. A lithography method in accordance with any of the preceding claims, **characterized in that** the resist material of the resist layer (3) is selected from the following group:
- calixarene and/ or resorcinarene derivatives, such as C-methylcalix[4]resorcinarene or 4-methyl-1-acetoxycalix[6]arene or derivatives of calixarenes and resorcinarenes, which are also correspondingly chemically functionalized for Langmuir-Blodgett, self-assembly or vapor deposition layer preparation techniques;
- resist material which does not comprise macromolecules and/or chain molecules, but rather single molecules which have a spatial extent ≤ 2nm, which are only connected to one another by non-covalent bonds in a non-chain-like state and which form a solid resist layer of 1 to 100 nm, wherein the resist molecules are **characterized by** an exactly defined chemical composition, chemical structure and geometric extent and a monodisperse minimum molecular weight, for example, fullerene-based resist materials and derivatives thereof and other molecular glass resist materials;
- so-called hybrid materials which are composed of organic and inorganic components such as Au(I)-calix(4)arene diphosphine molecular complexes or nanoparticle calixarene complexes;
- chemically reinforced resist materials;
- polymer-based resist materials such as PMMA; and
- special electron beam-specific organic and/or inorganic resist materials such as HSQ.

7. A lithography method in accordance with any of the preceding claims 1 to 6, wherein either
the resist still remaining after the development has been crosslinked by the rough structuring and the resist not removed by the fine structuring is removed in a localized manner or left localized in the sense of a further fine structuring by using the same scanning probe lithography device (18) or
the resist still remaining after the development is not crosslinked by the rough structuring and the resist not removed by the fine structuring is crosslinked in a localized manner in the sense of a further fine structuring by using the same scanning probe lithography device (18).

8. A lithography method in accordance with claim 7, **characterized in that**
various interaction mechanisms between the tip and the resist layer, which are expressed by a local chemical modification of the resist material or a local removal of the resist material or both, are set by selecting a parameter set for the scanning probe comprising an electrical potential difference; an electron dose which is composed of the current value and the writing speed of the scanning probe; environmental conditions and environmental parameters such as the surrounding gases and their partial pressure, the present temperature or the air humidity; the tip (4) of the scanning probe, the resist material (3); and the spacing between the tip (4) and the resist layer (3).

9. A lithography method in accordance with claim 7 or claim 8, **characterized in that** a structuring is made possible by the combination of a cross-linking and a local removal of resist material, which enables a generation of structures by means of positive resist behavior or negative resist behavior or both in combination.

10. A lithography method in accordance with any one of the preceding claims 7 to 9, **characterized in that** the scanning probe lithography device (18) is designed such that the angle between the substrate (1) and the cantilever (5) is variable, whereby it becomes possible to operate the scanning probe lithography device both in a conventional dynamic mode at an angle between 10° and 12° between the substrate and the cantilever and in a so-called shear-force mode at a 90° angle between the substrate and the cantilever, whereby the dynamic mode is **characterized in that** the tip (4) arranged at the end of the cantilever oscillates almost perpendicular to the substrate surface, depending on the preset angle, whereas, in the so-called shear-force operation, the cantilever (5) oscillates almost in parallel with only a minimal vertical oscillation portion with respect to the reference plane of the substrate surface.

11. A lithography apparatus comprising
- a lithography device (20) which is adapted to perform a rough structuring of a resist layer (3) present on a substrate (1);
- a scanning probe lithography device to perform, after the rough structuring, a fine structuring of the same resist layer (3), directly in the same lithography region or in an overlapping manner, wherein the scanning probe lithography device is equipped with a plurality of cantilevers (5) which are arranged in a matrix, which are deflectable in a controlled manner and which each have a tip (4); with a scanner device to perform a relative scanning movement of the matrix arrangement of the cantilevers (5) relative to a holder or a table (6) carrying the substrate (1); and with a device to set the spacing between the tips (4) of the cantilevers and the substrate surface; and
- an alignment device which is associated with the scanning probe lithography device and which is adapted for aligning the scanning probe lithography device with respect to a pre-structured substrate or a roughly structured resist layer,
wherein the lithography apparatus is configured to coat a substrate (1) with the resist (3) in a preparatory step, to treat the coated substrate by means of a mask-based optical lithography or by means of a maskless electron beam lithography or ion beam lithography, to perform a development process in a further treatment step, and to locally remove the resist still remaining after the development by means of a scanning probe-based closed loop lithography in a subsequent lithography step.

12. A lithography apparatus in accordance with claim 11, **characterized in that** the beam-based lithography device (20) is adapted for performing a mask-based DUV lithography method, EUV lithography method or X-ray lithography method.

## Revendications

1. Procédé de lithographie, dans lequel un champ électrique généré par une sonde de balayage et un courant d'électrons par émission de champ, effet tunnel ou de Faraday qui en résulte sont utilisés pour produire une structuration fine d'une couche de réserve (3), dans lequel avant la structuration fine, une structuration grossière de la même couche de réserve (3) est effectuée au moyen d'une méthode de lithographie par rayonnement, dans lequel la structuration grossière et la structuration fine sont effectuées directement dans la même zone de lithographie ou en chevauchement,
dans lequel, dans une étape préparatoire, un substrat (1) est revêtu de la réserve (3), le substrat revêtu est traité au moyen d'une lithographie optique avec masque ou d'une lithographie à faisceau d'électrons ou d'ions sans masque, dans une étape de traitement supplémentaire un procédé de développement est exécuté et, dans une étape de lithographie suivante, la réserve restant après le développement est éliminée localement au moyen d'une lithographie en boucle fermée à sonde de balayage.

2. Procédé de lithographie selon la revendication 1, **caractérisé en ce que** la sonde de balayage est utilisée pour déterminer la position exacte de la structuration grossière avant d'effectuer la structuration fine.

3. Procédé de lithographie selon la revendication 1 ou 2, **caractérisé en ce que** la méthode de lithographie par rayonnement est choisie dans le groupe constitué par la lithographie par faisceau d'électrons, la lithographie par faisceau d'ions et la lithographie DUV, EUV ou par rayons X avec masque.

4. Procédé de lithographie selon l'une des revendications précédentes, **caractérisé en ce que** le procédé de développement est un procédé de développement par voie chimique humide, thermique ou par laser.

5. Procédé de lithographie selon l'une des revendications 1 à 3 précédentes, **caractérisé en ce que** le substrat (1) est traité ensuite par des processus suivants tels que transfert de structures, lift-off, implantation ou métallisation, ALD.

6. Procédé de lithographie selon l'une des revendications précédentes, **caractérisé en ce que** le matériau de réserve de la couche de réserve (3) est choisi dans le groupe suivant :
- dérivés de calixarènes et/ou de résorcinarènes, tels que C-méthylcalix[4]résorcinarène, ou 4-méthyl-1-acétoxycalix[6]arène, ou dérivés de calixarènes et de résorcinarènes qui sont également fonctionnalisés chimiquement en conséquence pour des techniques de préparation de couche Langmuir-Blodgett, par auto-assemblage ou dépôt en phase vapeur ;
- matériau de réserve qui n'est pas constitué de macromolécules et/ou de molécules en chaîne, mais de molécules individuelles ayant une extension spatiale ≤ 2 nm, qui sont reliées entre elles dans un état non en forme de chaîne, uniquement par des liaisons non covalentes, et forment une couche de réserve solide de 1 à 100 nm, les molécules de réserve étant **caractérisées par** une composition chimique, une structure chimique, une extension géométrique et un poids moléculaire minimal monodispersé exactement définis, par exemple des matériaux de réserve à base de fullerènes et leurs dérivés et d'autres matériaux de réserve moléculaires vitreux ;
- matériaux dits hybrides, qui sont composés de composants organiques et inorganiques, tels que les complexes moléculaires Au(I)-calix(4)arène diphosphine ou les complexes nanoparticules-calixarène ;
- matériaux de réserve chimiquement amplifiés ;
- matériaux de réserve à base de polymères tels que le PMMA ;
- matériaux de réserve organiques et/ou inorganiques spéciaux spécifiques au faisceau d'électrons, tels que le HSQ.

7. Procédé de lithographie selon l'une quelconque des revendications 1 à 6 précédentes, dans lequel soit
la réserve restant après le développement a été réticulée par la structuration grossière et la réserve non éliminée par la structuration fine est éliminée localement ou laissée en place localement en utilisant le même moyen de lithographie à sonde de balayage (18) dans le sens d'une structuration fine supplémentaire, soit
la réserve restant après le développement n'est pas réticulée par la structuration grossière et la réserve non éliminée par la structuration fine est réticulée localement en utilisant le même moyen de lithographie à sonde de balayage (18) dans le sens d'une structuration fine supplémentaire.

8. Procédé de lithographie selon la revendication 7, **caractérisé en ce que** la sélection d'un ensemble de paramètres pour la sonde de balayage, consistant en une différence de potentiel électrique, une dose d'électrons, qui se compose de la valeur du courant et de la vitesse d'écriture de la sonde de balayage, de conditions ambiantes et de paramètres ambiants, tels que les gaz environnants et leur pression partielle, la température ou l'humidité de l'air ambiante, la pointe (4) de la sonde à balayage, le matériau de réserve (3) et la distance entre la pointe (4) et la couche de réserve (3), permet de régler différents mécanismes d'interaction entre la pointe et la couche de réserve, qui s'expriment par une modification chimique locale du matériau de réserve ou une élimination locale du matériau de réserve, ou les deux.

9. Procédé de lithographie selon la revendication 7 ou 8, **caractérisé en ce que** la combinaison d'une réticulation et d'une élimination locale du matériau de réserve permet une structuration, ce qui permet de créer des structures au moyen d'un comportement de réserve positif ou d'un comportement de réserve négatif ou des deux en combinaison.

10. Procédé de lithographie selon l'une des revendications 7 à 9 précédentes, **caractérisé en ce que** le moyen de lithographie à sonde de balayage (18) est conçu de telle sorte que l'angle entre le substrat (1) et le cantilever (5) est variable, ce qui permet de faire fonctionner le moyen de lithographie à sonde de balayage aussi bien dans le mode dynamique classique à un angle compris entre 10° et 12° entre le substrat et le cantilever que dans le mode dit à force de cisaillement à un angle de 90° entre le substrat et le cantilever, le mode dynamique **se caractérisant par le fait que** la pointe (4) située à l'extrémité du cantilever oscille presque perpendiculairement à la surface du substrat, en fonction de l'angle préréglé, tandis que dans le mode dit à force de cisaillement, le cantilever (5) oscille presque parallèlement avec seulement une composante d'oscillation verticale minimale par rapport au plan de référence de la surface du substrat.

11. Dispositif de lithographie, comprenant
- un moyen de lithographie (20) qui est conçu pour effectuer une structuration grossière d'une couche de réserve (3) présente sur un substrat (1),
- un moyen de lithographie à sonde de balayage pour effectuer, après la structuration grossière, une structuration fine de la même couche de réserve (3), directement dans la même zone de lithographie ou en chevauchement, le moyen de lithographie à sonde de balayage étant équipé de plusieurs cantilevers (5) pouvant être déviés de manière commandée et disposés en une matrice, qui présentent chacun une pointe (4), avec un dispositif de balayage pour effectuer un mouvement de balayage relatif de l'agencement matriciel des cantilevers (5) par rapport à un support ou une table (6) portant le substrat (1) et avec un moyen pour régler la distance entre les pointes des cantilevers et la surface du substrat, ainsi que
- un moyen d'orientation associé au moyen de lithographie à sonde de balayage, qui est conçu pour orienter le moyen de lithographie à sonde de balayage par rapport à un substrat préstructuré ou une couche de réserve grossièrement structurée,
le dispositif de lithographie étant conçu, dans une étape préparatoire, pour revêtir un substrat (1) avec la réserve (3), pour traiter le substrat revêtu au moyen d'une lithographie optique avec masque ou d'une lithographie à faisceau d'électrons ou d'ions sans masque, dans une étape de traitement supplémentaire pour exécuter un procédé de développement et, dans une étape de lithographie suivante, pour éliminer localement la réserve restant après le développement au moyen d'une lithographie en boucle fermée à sonde de balayage.

12. Dispositif de lithographie selon la revendication 11, **caractérisé en ce que** le moyen de lithographie par rayonnement (20) est conçu pour exécuter un procédé de lithographie DUV, EUV ou par rayons X avec masque.
